(19) Europäisches Patentamt
European Patent Office
Office européen des brevets

(11) EP 4 471 834 B1

(12) **EUROPEAN PATENT SPECIFICATION**

(45) Date of publication and mention of the grant of the patent:
**04.03.2026 Bulletin 2026/10**

(21) Application number: **22922199.9**

(22) Date of filing: **23.12.2022**

(51) International Patent Classification (IPC):
***C09G 1/02*** $^{(2006.01)}$ ***C09K 3/14*** $^{(2006.01)}$
***H01L 21/306*** $^{(2006.01)}$ ***H01L 21/3105*** $^{(2006.01)}$
***H01L 21/321*** $^{(2006.01)}$ ***B24B 37/04*** $^{(2012.01)}$

(52) Cooperative Patent Classification (CPC):
**H10P 95/062; B24B 37/044; C09G 1/02; C09K 3/1409; C09K 3/1454; C09K 3/1463; H10P 52/00; H10P 52/402; H10P 52/403**

(86) International application number:
**PCT/JP2022/047646**

(87) International publication number:
**WO 2023/140049 (27.07.2023 Gazette 2023/30)**

(54) **POLISHING SOLUTION AND POLISHING METHOD**

POLIERLÖSUNG UND POLIERVERFAHREN

SOLUTION DE POLISSAGE ET PROCÉDÉ DE POLISSAGE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **24.01.2022 JP 2022008480**

(43) Date of publication of application:
**04.12.2024 Bulletin 2024/49**

(73) Proprietor: **FUJIFILM Corporation**
**Tokyo 106-8620 (JP)**

(72) Inventor: **KAMIMURA, Tetsuya**
**Haibara-gun, Shizuoka 421-0396 (JP)**

(74) Representative: **HGF**
**HGF Limited**
**4th Floor, 1 City Square**
**Leeds LS1 2ES (GB)**

(56) References cited:
**WO-A1-2016/060113**
**GB-A- 2 385 057**
**GB-A- 2 403 954**
**JP-A- 2019 062 078**
**JP-A- 2020 164 658**
**US-A1- 2020 308 450**
**US-B2- 9 631 121**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## BACKGROUND OF THE INVENTION

1. Field of the Invention

The present invention relates to a polishing liquid and a polishing method.

2. Description of the Related Art

In the development of a semiconductor device represented by a semiconductor integrated circuit (LSI), there is a demand for higher density and higher integration through miniaturization and lamination of a wiring line in order to reduce size and increase speed. Various techniques such as chemical mechanical polishing (CMP) have been used as a technique for this purpose. This CMP is a technique which is used in a case of carrying out surface flattening of a film to be processed such as an interlayer insulating film, formation of a plug, formation of an embedded metal wire, or the like, and carries out flattening of a substrate or the like.

The general method of CMP is carried out in such a manner that a polishing pad is attached onto a circular polishing platen, a polishing liquid is supplied to a surface of the polishing pad, a surface of a substrate (a surface to be polished) is brought into contact with the polishing pad, both the polishing platen and the substrate are rotated and moved relative to each other while applying a predetermined pressure from a back surface of the substrate (the side opposite to the surface to be polished), and the surface of the substrate is flattened by the chemical action of the polishing liquid and the generated mechanical friction.

Examples of the polishing liquid used in CMP include a polishing liquid containing abrasive particles and a component which exerts a chemical action on an object to be polished such as a substrate. For example, the polishing liquid disclosed in JP2010-041037A is a polishing liquid for silicon nitride, containing colloidal silica, a predetermined organic acid, and water, and having a pH of 2.5 to 5.0.

## SUMMARY OF THE INVENTION

With the further miniaturization of a semiconductor device in recent years, there is also an increasing requirement for accuracy in the CMP treatment, and there is also a demand for reducing a variation in polishing rate in a case of carrying out the CMP treatment using a polishing liquid.

As a result of studies on the polishing liquid disclosed in JP2010-041037A, the present inventors have found that, in a case where silicon nitride or polysilicon is used as an object to be polished, the polishing liquid exhibits a large variation in polishing rate and does not satisfy the recent demand level.

In addition, in the CMP treatment, it is also required that the polishing rate is high.

Therefore, an object of the present invention is to provide a polishing liquid having a high polishing rate and exhibiting a small variation in polishing rate in a case where polishing is carried out using a polishing liquid (in particular, exhibiting a small variation in polishing rate in a case where silicon nitride or polysilicon is used as a polishing target).

Another object of the present invention is to provide a polishing method using a polishing liquid.

As a result of extensive studies to achieve the foregoing objects, the present inventors have completed the present invention. That is, the present inventors have found that the foregoing objects can be achieved by the following configurations.

[1] A polishing liquid for use in chemical mechanical polishing, the polishing liquid comprising colloidal silica, an organic acid having at least a phosphonic acid group or a salt thereof in a molecular structure, hypophosphorous acid, and water.

[2] The polishing liquid according to [1], in which the polishing liquid has a pH of 2.5 to 5.0.

[3] The polishing liquid according to [1] or [2], in which a content of the colloidal silica is 1% to 5% by mass with respect to a total mass of the polishing liquid.

[4] The polishing liquid according to any one of [1] to [3], in which an average primary particle diameter of the colloidal silica is 5 to 100 nm, and an average secondary particle diameter of the colloidal silica is 10 to 300 nm.

[5] The polishing liquid according to any one of [1] to [4], in which the organic acid is 1-hydroxyethane-1,1-diphosphonic acid.

[6] The polishing liquid according to any one of [1] to [5], in which a content of the hypophosphorous acid is $1.0 \times 10^{-8}$% to $5.0 \times 10^{-3}$% by mass with respect to a total mass of the polishing liquid.

[7] The polishing liquid according to any one of [1] to [6], in which a mass ratio of a content of the hypophosphorous acid to a content of the organic acid is $1.0 \times 10^{-8}$ to $2.0 \times 10^{-4}$.

[8] The polishing liquid according to any one of [1] to [7], further comprising phosphonic acid.
[9] The polishing liquid according to [8], in which a content of the phosphonic acid is $1.0 \times 10^{-9}$% to $5.0 \times 10^{-4}$% by mass with respect to a total mass of the polishing liquid.
[10] The polishing liquid according to [8] or [9], in which a mass ratio of a content of the phosphonic acid to the content of the organic acid is $1.0 \times 10^{-9}$ to $1.0 \times 10^{-4}$.
[11] The polishing liquid according to any one of [1] to [10], further comprising phosphoric acid.
[12] The polishing liquid according to [11], in which a mass ratio of a content of the phosphoric acid to a content of the organic acid is $1.5 \times 10^{-8}$ to $3.0 \times 10^{-5}$.
[13] The polishing liquid according to [11] or [12], in which a mass ratio of a content of the phosphoric acid to a content of the hypophosphorous acid is $1.0 \times 10^{-4}$ to $1.0 \times 10^{1}$.
[14] The polishing liquid according to any one of [1] to [13], further comprising phosphonic acid and phosphoric acid, in which a mass ratio of the content of the phosphoric acid to the content of the phosphonic acid is $1.0 \times 10^{-2}$ to $1.0 \times 10^{2}$.
[15] The polishing liquid according to any one of [1] to [14], further comprising ammonia.
[16] The polishing liquid according to any one of [1] to [15], further comprising a surfactant having a sulfonic acid group or a salt thereof in a molecular structure.
[17] The polishing liquid according to [16], in which the surfactant contains alkylbenzenesulfonic acid or a salt thereof or a derivative of alkylbenzenesulfonic acid or a salt thereof.
[18] The polishing liquid according to [16] or [17], in which the surfactant contains alkyl diphenyl ether disulfonic acid or a salt thereof or a derivative of alkyl diphenyl ether disulfonic acid or a salt thereof.
[19] The polishing liquid according to any one of [16] to [18], in which the surfactant contains a first surfactant selected from the group consisting of alkyl diphenyl ether disulfonic acid having an alkyl group having 12 carbon atoms or a salt thereof, and a derivative of alkyl diphenyl ether disulfonic acid having an alkyl group having 12 carbon atoms or a salt thereof, and a second surfactant selected from the group consisting of alkyl diphenyl ether disulfonic acid having an alkyl group having 13 carbon atoms or a salt thereof, and a derivative of alkyl diphenyl ether disulfonic acid having an alkyl group having 13 carbon atoms or a salt thereof, and a mass ratio of a content of the second surfactant to a content of the first surfactant is $2.0 \times 10^{-2}$ to $3.0 \times 10^{-1}$.
[20] The polishing liquid according to any one of [16] to [18], in which the surfactant contains alkyl diphenyl ether disulfonic acid or a salt thereof, and one or more compounds selected from the group consisting of alkyl diphenyl ether trisulfonic acid or a salt thereof, and alkyl diphenyl ether tetrasulfonic acid or a salt thereof.
[21] The polishing liquid according to [20], in which a mass ratio of a total content of one or more compounds selected from the group consisting of the alkyl diphenyl ether trisulfonic acid or the salt thereof and the alkyl diphenyl ether tetrasulfonic acid or the salt thereof to a content of the alkyl diphenyl ether disulfonic acid or the salt thereof is $1.0 \times 10^{-3}$ to $1.0 \times 10^{-1}$.
[22] The polishing liquid according to any one of [1] to [21], further comprising sulfuric acid.
[23] The polishing liquid according to [22], in which a mass ratio of a content of the sulfuric acid to a content of the organic acid is $1.0 \times 10^{-5}$ to $3.0 \times 10^{-1}$.
[24] The polishing liquid according to any one of [1] to [23], further comprising a surfactant having a sulfonic acid group or a salt thereof in a molecular structure and sulfuric acid, in which a mass ratio of the content of the sulfuric acid to a content of the surfactant is $3.0 \times 10^{-5}$ to $5.0 \times 10^{-1}$.
[25] The polishing liquid according to any one of [1] to [24], in which, in a flattening step in a case of producing a semiconductor integrated circuit, the polishing liquid is used for chemical mechanical polishing of an object to be polished, which has a first layer containing silicon nitride, and a second layer containing at least one silicon-based compound selected from the group consisting of polysilicon, modified polysilicon, silicon oxide, silicon carbide, and silicon carbide oxide.
[26] A polishing method comprising supplying the polishing liquid according to any one of [1] to [25] to a polishing pad on a polishing platen, rotating the polishing platen, and bringing the polishing pad and a surface to be polished of an object to be polished into contact and moving relative to each other.

According to the present invention, it is possible to provide a polishing liquid having a high polishing rate and exhibiting a small variation in polishing rate in a case where polishing is carried out using a polishing liquid (in particular, exhibiting a small variation in polishing rate in a case where silicon nitride or polysilicon is used as a polishing target).
In addition, it is also possible to provide a polishing method using a polishing liquid.

## BRIEF DESCRIPTION OF THE DRAWINGS

Fig. 1 is a cross-sectional view of a laminate obtained in a process of creating an object to be polished used for evaluation of Examples.

## DESCRIPTION OF THE PREFERRED EMBODIMENTS

Hereinafter, the present invention will be described in more detail.

The description of the configuration requirements described below may be made based on the representative embodiments of the present invention, but the present invention is not limited to such embodiments.

Hereinafter, the meaning of each description in the present specification will be expressed.

**In** the present specification, any numerical range expressed by using "to" means a range including the numerical values before and after the "to" as a lower limit value and an upper limit value, respectively.

**In** the present specification, in a case where two or more types of a certain component are present, the "content" of the component means a total content of the two or more types of components.

<Polishing liquid>

The polishing liquid according to an embodiment of the present invention is a polishing liquid for use in chemical mechanical polishing (CMP), containing colloidal silica, an organic acid having at least a phosphonic acid group or a salt thereof in a molecular structure, hypophosphorous acid, and water.

Although the mechanism for a high polishing rate and a small variation in polishing rate in a case where polishing is carried out using the polishing liquid according to the embodiment of the present invention is not necessarily clear, the present inventors speculate as follows.

Since the polishing liquid according to the embodiment of the present invention contains the above-mentioned organic acid and water, the polishing liquid acts chemically on a surface of an object to be polished, and can accelerate a polishing rate based on a mechanical action of colloidal silica. Further, since the polishing liquid according to the embodiment of the present invention contains hypophosphorous acid, the above-mentioned chemical action on the surface of the object to be polished can be stabilized.

**In** addition, through studies conducted by the present inventors, it has been found that the variation in polishing rate is reduced in a case where the polishing liquid contains hypophosphorous acid. Specifically, the polishing rate is usually calculated as an average value of the polishing rates for the entire surface of a wafer such as a 12-inch wafer, but the polishing rate in the vicinity of the outer periphery (in the vicinity of edge area and outer periphery) of the wafer often varies, and therefore the overall polishing rate often varies. Here, it has been found that, in a case where the polishing liquid contains hypophosphorous acid, the variation in polishing rate in the vicinity of the outer periphery of the wafer is reduced, and the variation in overall polishing rate is also reduced.

As a result, in a case where the polishing liquid according to the embodiment of the present invention is used, the polishing rate can be increased and the variation in polishing rate can be reduced.

Hereinafter, the components that can be contained in the polishing liquid according to the embodiment of the present invention will be described.

Hereinafter, the expression that the polishing rate in a case of carrying out polishing using a polishing liquid is high is also simply referred to as "excellent in polishing rate", and the expression that a variation in polishing rate in a case of carrying out polishing using a polishing liquid is reduced is also simply referred to as "the variation in polishing rate is small".

[Colloidal silica]

The polishing liquid according to the embodiment of the present invention contains colloidal silica.

It is noted that the expression "colloidal silica" refers to silica (silicon oxide) particles that are colloidally dispersed in a dispersion medium, and the expression "containing colloidal silica" refers to containing silica particles that can be colloidally dispersed. That is, the content of the colloidal silica represents the content of the silica particles.

It is preferable that the colloidal silica does not contain impurities such as an alkali metal inside the particles. The colloidal silica as described above is obtained by hydrolysis of alkoxysilane.

The particle diameter of the colloidal silica may be appropriately selected depending on the purpose of use.

The average primary particle diameter of the colloidal silica is preferably 1 to 1,000 nm, more preferably 5 to 100 nm, still more preferably 10 to 100 nm, and particularly preferably 10 to 80 nm.

The average primary particle diameter of the colloidal silica refers to a particle diameter (median diameter) at which, in a case where a volume-based integrated particle size distribution curve is obtained, a value of the integrated distribution of this curve is 50%. The above-mentioned integrated particle size distribution curve is obtained by measuring an equivalent circle diameter of colloidal silica using a transmission electron microscope or the like and converting the measured equivalent circle diameter into a volume-based value. It is noted that the equivalent circle diameter is a diameter of a perfect circle assumed to have the same projected area as the projected area of the colloidal silica at the time of observation.

The average secondary particle diameter of the colloidal silica is preferably 5 to 2,000 nm, more preferably 10 to

300 nm, still more preferably 20 to 200 nm, and particularly preferably 20 to 150 nm.

The average secondary particle diameter of the colloidal silica refers to an average particle diameter of secondary particles formed by the partial association of the colloidal silica. The above-mentioned average secondary particle diameter represents an average particle diameter determined from a particle size distribution obtained by a dynamic light scattering method. An example of a particle size distribution determination device based on the dynamic light scattering method is LB-500 manufactured by Horiba, Ltd.

A commercially available product may be used as the colloidal silica.

Examples of the commercially available product of the colloidal silica include PL series (PL-05, PL-1, PL-2, PL-3, and the like) manufactured by Fuso Chemical Co., Ltd.

The content of the colloidal silica is preferably 0.1% to 10% by mass, more preferably 0.5% to 10% by mass, and still more preferably 1% to 5% by mass with respect to the total mass of the polishing liquid.

The polishing liquid according to the embodiment of the present invention may contain abrasive grains other than the colloidal silica.

Examples of the abrasive grains other than the colloidal silica include fumed silica, ceria, alumina, and titania. The average primary particle diameter of the abrasive grains other than the colloidal silica is preferably 1 to 2 times the average primary particle diameter of the colloidal silica.

The content of the colloidal silica with respect to the total of the colloidal silica and the abrasive grains other than the colloidal silica is preferably 50% by mass or more, more preferably 80% by mass or more, and still more preferably 99% by mass or more. The upper limit of the above-mentioned content is 100% by mass, and the content of the colloidal silica may be 100% by mass.

[Organic acid]

The polishing liquid according to the embodiment of the present invention contains an organic acid having at least a phosphonic acid group or a salt thereof in a molecular structure. Hereinafter, the organic acid having at least a phosphonic acid group or a salt thereof in a molecular structure is also simply referred to as an "organic acid".

The number of phosphonic acid groups or salts thereof in the molecular structure is not particularly limited, and is preferably 1 to 10, more preferably 1 to 6, still more preferably 1 to 4, and particularly preferably 2 to 4.

The organic acid is preferably a compound represented by General Formula (I).

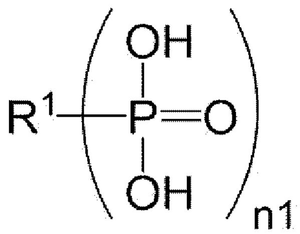 (I)

In General Formula (I), n1 represents an integer of 1 to 4.

In a case where n1 is 1, $R^1$ in General Formula (I) represents an alkyl group having 1 to 8 carbon atoms, an alkynyl group, a cycloalkyl group, an aryl group, a heterocyclic group, or a combination of two or more thereof. The above-mentioned groups may each have a substituent.

The alkyl group having 1 to 8 carbon atoms may be linear or branched. Examples of the alkyl group having 1 to 8 carbon atoms include a methyl group, an ethyl group, a propyl group, a butyl group, a pentyl group, a hexyl group, a heptyl group, and an octyl group, among which a methyl group, an ethyl group, a propyl group, a butyl group, or a pentyl group is preferable.

The alkynyl group is preferably an alkynyl group having 2 to 6 carbon atoms, specific examples of which include an ethynyl group, a propynyl group, a butynyl group, a pentynyl group, and a hexynyl group, among which an ethynyl group, a propynyl group, a butynyl group, or a pentynyl group is preferable.

Specific examples of the cycloalkyl group include a cyclohexyl group and a cyclopentyl group, among which a cyclohexyl group is preferable.

Specific examples of the aryl group include a phenyl group and a naphthyl group, among which a phenyl group is preferable.

Specific examples of the heterocyclic group include a pyridyl group.

The group represented by the above-mentioned $R^1$ may be further substituted with another substituent. The other substituent is preferably a hydrophilic group, among which a phosphate group, a hydroxy group, a thiol group, an amino group ($-NH_2$), a hydroxyamino group (-NHOH), or a carboxy group is preferable.

A methylene group in the group represented by the above-mentioned $R^1$ may be substituted with a divalent linking group containing a heteroatom. The divalent linking group containing a heteroatom is preferably a secondary amino group (-NH-), a tertiary amino group (-$NR^T$-), -O-, or -CO-. $R^T$ represents an alkyl group having 1 to 6 carbon atoms which may have a substituent. As the above-mentioned substituent, the above-mentioned other substituents are preferably mentioned.

In a case where n1 is 2 to 4, $R^1$ in General Formula (I) represents an n-valent linking group.

The divalent linking group represented by $R^1$ is preferably an alkylene group, a phenylene group, -NH-, -$NR^T$-, or a combination thereof. $R^T$ represents an alkyl group having 1 to 6 carbon atoms which may have a substituent. The alkylene group may be linear or branched, and a hydrogen atom of the alkylene group may be substituted with other substituents described above. The number of carbon atoms in the alkylene group is preferably 1 to 3.

The trivalent linking group represented by $R^1$ is preferably a group formed by removing one hydrogen atom from an alkylene group, a group formed by removing one hydrogen atom from a phenylene group, or N(-alkylene group)$_3$. The alkylene group may be linear or branched, and a hydrogen atom of the alkylene group may be substituted with other substituents described above. The number of carbon atoms in the alkylene group is preferably 1 to 3.

The tetravalent linking group represented by $R^1$ is preferably a group formed by removing two hydrogen atoms from an alkylene group, a group formed by removing two hydrogen atoms from a phenylene group, or (alkylene group-)$_2$N-alkylene group-N(-alkylene group)$_2$. The alkylene group may be linear or branched, and a hydrogen atom of the alkylene group may be substituted with other substituents described above. The number of carbon atoms in the alkylene group is preferably 1 to 3.

Specific examples of the organic acid are shown below, but the organic acid contained in the polishing liquid according to the embodiment of the present invention is not limited to these specific examples.

B1

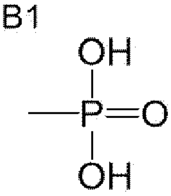

B2

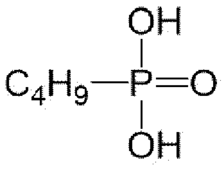

B3

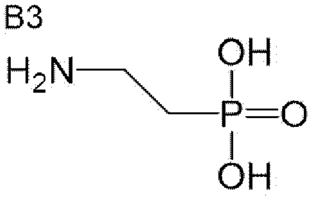

B4

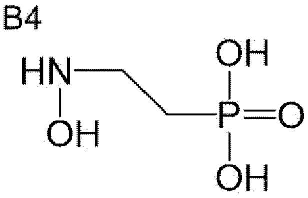

B5

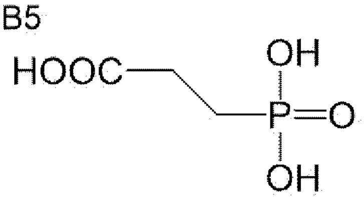

B6

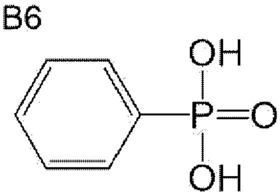

B7

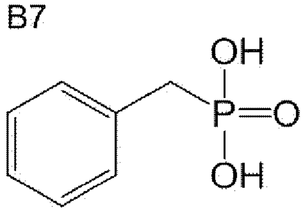

B8

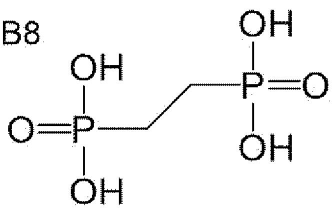

B9

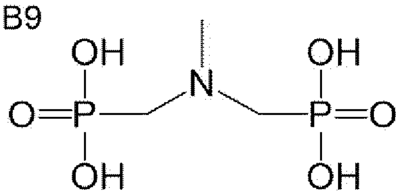

B10

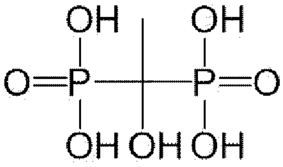

B11

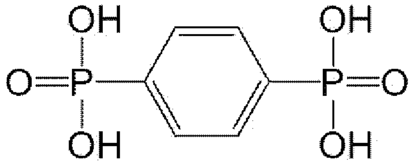

B12

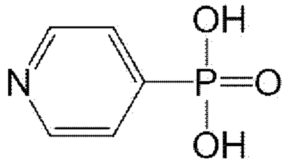

B13

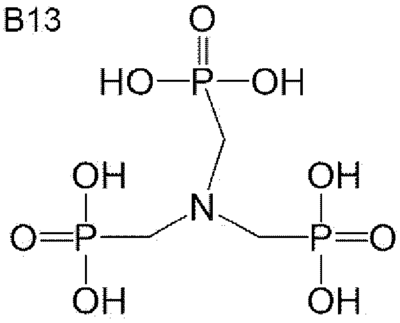

B14

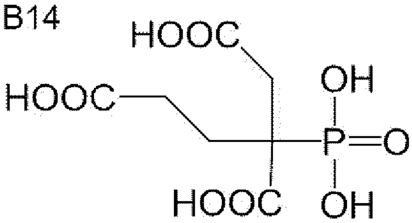

B15

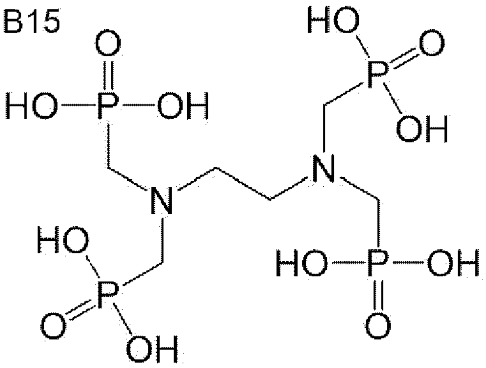

Above all, the organic acid is preferably 1-hydroxyethane-1,1-diphosphonic acid (also referred to as etidronic acid or HEDP) represented by B10 above, tris(phosphonomethyl)amine represented by B13 above, or ethylenediamine tetramethylenephosphonic acid represented by B15 above, and more preferably HEDP.

From the viewpoint of small variation in polishing rate, the content of the organic acid is preferably 0.01% to 20% by mass, more preferably 0.05% to 15% by mass, still more preferably 0.1% to 10% by mass, and particularly preferably 1% to 10% by mass with respect to the total mass of the polishing liquid.

One type of organic acid may be used alone, or two or more types of organic acids may be used in combination.

In a case where two or more types of organic acids are used in combination, the total amount thereof is preferably within the above-mentioned range.

[Hypophosphorous acid]

The polishing liquid according to the embodiment of the present invention contains hypophosphorous acid ($H_3PO_2$).

From the viewpoint of small variation in polishing rate, the content of the hypophosphorous acid is preferably $1.0 \times 10^{-9}$% to $1.0 \times 10^{0}$% by mass, more preferably $1.0 \times 10^{-8}$% to $5.0 \times 10^{-3}$% by mass, and still more preferably $1.0 \times 10^{-6}$% to $1.0 \times 10^{-3}$% by mass with respect to the total mass of the polishing liquid.

In addition, the mass ratio of the content of the hypophosphorous acid to the content of the organic acid is preferably $1.0 \times 10^{-9}$ to $1.0 \times 10°$, more preferably $1.0 \times 10^{-8}$ to $2.0 \times 10^{-4}$, and still more preferably $1.0 \times 10^{-7}$ to $1.0 \times 10^{-4}$.

The content of the hypophosphorous acid can be measured by detecting a hypophosphite ion ($H_2PO_2^-$) by ion chromatography.

[Water]

The polishing liquid according to the embodiment of the present invention contains water.

The content of water is preferably 50% to 99% by mass, more preferably 70% to 95% by mass, and still more preferably 80% to 95% by mass with respect to the total mass of the polishing liquid.

[Phosphonic acid]

The polishing liquid according to the embodiment of the present invention may contain phosphonic acid ($H_3PO_3$).

The content of the phosphonic acid is preferably $1.0 \times 10^{-10}$% to $1.0 \times 10^{-3}$% by mass, more preferably $1.0 \times 10^{-9}$% to $5.0 \times 10$% by mass, and still more preferably $1.0 \times 10^{-8}$% to $2.0 \times 10$% by mass with respect to the total mass of the polishing liquid.

In addition, the mass ratio of the content of the phosphonic acid to the content of the organic acid is preferably 1.0

$\times 10^{-11}$ to $1.0 \times 10^{-1}$, more preferably $1.0 \times 10^{-9}$ to $1.0 \times 10^{-4}$, and still more preferably $5.0 \times 10^{-9}$ to $3.0 \times 10^{-6}$.

The content of the phosphonic acid can be measured by detecting a phosphonate ion ($HPO_3^{2-}$) by ion chromatography.

[Phosphoric acid]

The polishing liquid according to the embodiment of the present invention may contain phosphoric acid ($H_3PO_4$).

The content of the phosphoric acid is preferably $1.0 \times 10^{-10}$% to $1.0 \times 10^{-1}$% by mass, more preferably 1.0 x $10^{-9}$% to 1.0 x $10^{-2}$% by mass, and still more preferably 1.0 x $10^{-7}$% to 1.5 x $10^{-4}$% by mass with respect to the total mass of the polishing liquid.

The mass ratio of the content of the phosphoric acid to the content of the organic acid is preferably $1.0 \times 10^{-10}$ to $1.0 \times 10^{-2}$, more preferably $1.0 \times 10^{-9}$ to $5.0 \times 10$, and still more preferably $1.5 \times 10^{-8}$ to $3.0 \times 10^{-5}$.

The mass ratio of the content of the phosphoric acid to the content of the hypophosphorous acid is preferably $1.0 \times 10^{-6}$ to $1.0 \times 10^{2}$ and more preferably $1.0 \times 10^{-4}$ to $1.0 \times 10^{1}$.

The mass ratio of the content of the phosphoric acid to the content of the phosphonic acid is preferably $1.0 \times 10^{-3}$ to $1.0 \times 10^{3}$ and more preferably $1.0 \times 10^{-2}$ to $1.0 \times 10^{2}$.

The content of the phosphoric acid can be measured by detecting a phosphate ion ($PO_4^{3-}$) by ion chromatography.

[pH adjuster]

The polishing liquid according to the embodiment of the present invention may contain a pH adjuster other than the above-mentioned components, in order to adjust the pH of the polishing liquid to the range shown in the latter part. Examples of the pH adjuster include an alkaline compound, an acidic compound, and a buffer member.

The pH adjuster is not particularly limited, and preferred examples thereof include an organic ammonium hydroxide such as tetraalkylammonium hydroxide; an alkanolamine such as diethanolamine, triethanolamine, or triisopropanolamine; an inorganic alkaline compound such as ammonia, sodium hydroxide, potassium hydroxide, or lithium hydroxide; an inorganic acid such as nitric acid; a carbonate such as sodium carbonate; a borate; a tetraborate; and a hydroxybenzoate. Above all, preferred is an inorganic alkaline compound, among which ammonia, sodium hydroxide, or potassium hydroxide is preferable, and ammonia is more preferable.

The content of the pH adjuster is preferably 0.0001 to 1.0 mol and more preferably 0.003 to 0.5 mol with respect to 1 L of the polishing liquid.

[Surfactant]

The polishing liquid according to the embodiment of the present invention may contain a surfactant.

The surfactant is not particularly limited, and examples thereof include a surfactant having a sulfonic acid group or a salt thereof in a molecular structure and a surfactant having an ethyleneoxy group in a molecular structure. Above all, it is preferable that the surfactant has a sulfonic acid group or a salt thereof in the molecular structure.

Examples of the surfactant having a sulfonic acid group or a salt thereof in a molecular structure include alkylbenzenesulfonic acid or a salt thereof, a derivative of alkylbenzenesulfonic acid or a salt thereof, alkyl ether sulfonic acid or a salt thereof, and a derivative of alkyl ether sulfonic acid or a salt thereof, among which alkylbenzenesulfonic acid or a salt thereof, or a derivative of alkylbenzenesulfonic acid or a salt thereof is preferable.

It is noted that the "derivative" of a compound refers to a compound that further has a substituent.

As the alkylbenzenesulfonic acid or the salt thereof or the derivative of alkylbenzenesulfonic acid or the salt thereof, a compound represented by General Formula (II) is preferable.

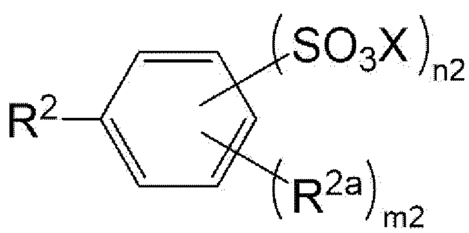

(II)

In General Formula (II), $R^2$ represents a group containing an alkyl chain; specifically, $R^2$ represents an alkyl group or a combination of an alkyl group with one or more groups selected from the group consisting of an alkenyl group, a cycloalkyl group, an aryl group, and an aralkyl group. The aryl group is preferably a phenyl group. Above all, $R^2$ preferably

represents an alkyl group, and more preferably represents a linear alkyl group. In a case where $R^2$ represents an alkyl group, the number of carbon atoms in the alkyl group is preferably 6 to 30, more preferably 10 to 30, and still more preferably 10 to 15. Specific examples of the alkyl group represented by $R^2$ include a hexyl group, an octyl group, a decyl group, an undecyl group, a dodecyl group, a tridecyl group, a tetradecyl group, a pentadecyl group, and an octadecyl group.

**In** General Formula (II), X's each independently represent a hydrogen atom, sodium, potassium, ammonium, diethanolamine, or triethanolamine, among which sodium, ammonium, diethanolamine, or triethanolamine is preferable.

In General Formula (II), n2 represents an integer of 1 to 5, and m2 represents an integer of 0 to 4. In this regard, n2 and m2 are selected such that n2 + m2 is an integer of 1 to 5. n2 is preferably 1 or 2. m2 is preferably 1 or 2.

In General Formula (II), $R^{2a}$'s each independently represent a substituent. Examples of the substituent represented by $R^{2a}$ include an alkyl group, an oxyalkyl group, an aryl group, and an oxyaryl group. A phenyl group is preferable as the aryl group and the aryl group of the oxyaryl group. The substituent represented by $R^{2a}$ may further have a substituent, and examples of the substituent that the substituent represented by $R^{2a}$ may further have include a sulfonic acid group or a salt thereof, a hydroxy group, and a carboxy group or a salt thereof.

The alkylbenzenesulfonic acid or the salt thereof or the derivative of alkylbenzenesulfonic acid or the salt thereof may be alkyl diphenyl ether disulfonic acid or a salt thereof or a derivative of alkyl diphenyl ether disulfonic acid or a salt thereof. The alkyl diphenyl ether disulfonic acid or the salt thereof or the derivative of alkyl diphenyl ether disulfonic acid or the salt thereof may be a compound represented by General Formula (III).

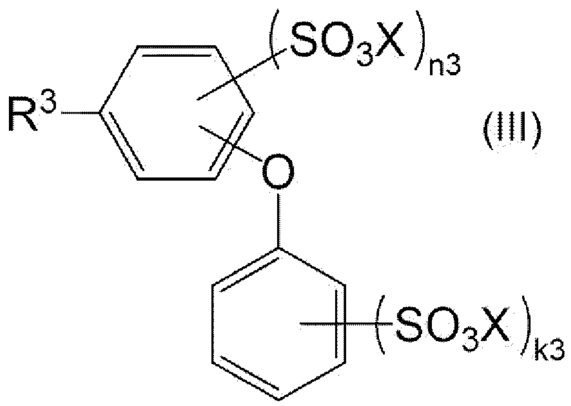

(III)

In General Formula (III), $R^3$ represents a group containing an alkyl chain, and specific aspects and preferred aspects thereof are the same as those of $R^2$ above.

In General Formula (III), X's each independently represent a hydrogen atom, sodium, potassium, ammonium, diethanolamine, or triethanolamine, among which sodium, ammonium, diethanolamine, or triethanolamine is preferable.

In General Formula (III), n3 represents 1 and k3 represents 1.

As the alkyl ether sulfonic acid or the salt thereof or the derivative of alkyl ether sulfonic acid or the salt thereof, a compound represented by General Formula (IV) is preferable.

$$R^4\text{-}((CH_2)_{k4}\text{-}O\text{-})_{n4}\text{-}SO_3X \qquad (IV)$$

In General Formula (IV), $R^4$ represents a group containing an alkyl chain, and specific aspects and preferred aspects thereof are the same as those of $R^2$ above.

In General Formula (IV), X's each independently represent a hydrogen atom, sodium, potassium, ammonium, diethanolamine, or triethanolamine, among which sodium, ammonium, diethanolamine, or triethanolamine is preferable.

In General Formula (IV), n4 represents an integer of 1 to 10, and k3 represents an integer of 1 to 3.

In addition, it is also preferable that the polishing liquid according to the embodiment of the present invention contains, as surfactants, a first surfactant selected from the group consisting of alkyl diphenyl ether disulfonic acid having an alkyl group having 12 carbon atoms or a salt thereof, and a derivative of alkyl diphenyl ether disulfonic acid having an alkyl group having 12 carbon atoms or a salt thereof, and a second surfactant selected from the group consisting of alkyl diphenyl ether disulfonic acid having an alkyl group having 13 carbon atoms or a salt thereof, and a derivative of alkyl diphenyl ether disulfonic acid having an alkyl group having 13 carbon atoms or a salt thereof.

In a case where the polishing liquid contains the first surfactant and the second surfactant, a mass ratio of a content of the second surfactant to a content of the first surfactant is preferably $1.0 \times 10^{-3}$ to $3.0 \times 10^{0}$ and more preferably $2.0 \times 10^{-2}$ to $3.0 \times 10^{-1}$.

In addition, in a case where the surfactant contains alkyl diphenyl ether disulfonic acid or a salt thereof, the

surfactant may contain one or more compounds selected from the group consisting of alkyl diphenyl ether trisulfonic acid or a salt thereof and alkyl diphenyl ether tetrasulfonic acid or a salt thereof (hereinafter, also referred to as "alkyl diphenyl ether polysulfonic acid or a salt thereof").

The alkyl diphenyl ether trisulfonic acid or the salt thereof is a compound in which, in General Formula (III), one of n3 and k3 represents 1, and the other of n3 and k3 represents 2.

The alkyl diphenyl ether tetrasulfonic acid or the salt thereof is a compound in which, in General Formula (III), n3 and k3 are 1 or more and n3 + k3 is 4.

In a case where the surfactant contains alkyl diphenyl ether disulfonic acid or a salt thereof and alkyl diphenyl ether polysulfonic acid or a salt thereof, a mass ratio of a total content of the alkyl diphenyl ether polysulfonic acid or the salt thereof to the alkyl diphenyl ether disulfonic acid or the salt thereof is preferably $1.0 \times 10^{-6}$ to $1.0 \times 10^{1}$, more preferably $1.0 \times 10^{-5}$ to $1.0 \times 10°$, and still more preferably $1.0 \times 10^{-3}$ to $1.0 \times 10^{-1}$.

In a case where the surfactant has a sulfonic acid group or a salt thereof in the molecular structure, the sulfonic acid group or the salt thereof may be a sulfonate ion ($-SO_3^-$) in the polishing liquid.

The content of the surfactant is preferably 0.1% to 5.0% by mass, more preferably 0.5% to 3.0% by mass, and still more preferably 0.5% to 2.0% by mass with respect to the total mass of the polishing liquid.

[Sulfuric acid]

The polishing liquid according to the embodiment of the present invention may contain sulfuric acid.

The content of the sulfuric acid is preferably $1.0 \times 10^{-5}$% to $5.0 \times 10^{0}$% by mass, more preferably $5.0 \times 10^{-5}$% to $1.0 \times 10^{0}$% by mass, and still more preferably $5.0 \times 10^{-3}$% to $1.0 \times 10^{-1}$% by mass with respect to the total mass of the polishing liquid.

The mass ratio of the content of the sulfuric acid to the content of the organic acid is preferably $1.0 \times 10^{-6}$ to $1.0 \times 10^{0}$, more preferably $1.0 \times 10^{-5}$ to $3.0 \times 10^{-1}$, still more preferably $1.0 \times 10^{-3}$ to $1.0 \times 10^{-2}$.

In a case where the polishing liquid contains a surfactant, the mass ratio of the content of the sulfuric acid to the content of the surfactant is preferably $1.0 \times 10^{-6}$ to $3.0 \times 10°$, more preferably $3.0 \times 10^{-5}$ to $5.0 \times 10^{-1}$, and still more preferably $1.0 \times 10^{-3}$ to $1.0 \times 10^{-1}$.

The content of the sulfuric acid can be measured by detecting a sulfate ion ($SO_4^{2-}$) by ion chromatography.

[Other Components]

The polishing liquid according to the embodiment of the present invention may contain components other than the foregoing components (other components). Hereinafter, the other components will be described.

(Other organic acids)

The polishing liquid according to the embodiment of the present invention may contain another organic acid in addition to the above-mentioned organic acid.

The other organic acid is preferably another water-soluble organic acid.

Examples of the other organic acid include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, hydroxyethyliminodiacetic acid, iminodiacetic acid, acetamidoiminodiacetic acid, nitrilotripropanoic acid, dihydroxyethylglycine, tricine, salts thereof such as ammonium salts and alkali metal salts, and mixtures thereof.

In addition, the other organic acid may be an amino acid. Examples of the amino acid include glycine, L-alanine, β-alanine, L-2-aminobutyric acid, L-norvaline, L-valine, L-leucine, L-norleucine, L-isoleucine, L-alloisoleucine, L- phenylalanine, L-proline, sarcosine, L-ornithine, L-lysine, taurine, L-serine, L-threonine, L-allothreonine, L-homoserine, L-tyrosine, 3,5-diiodo-L-tyrosine, (3-(3,4-dihydroxyphenyl)-L-alanine, L-thyroxin, 4-hydroxy-L-proline, L-cysteine, L-methionine, L-ethionine, L-lanthionine, L-cystathionine, L-cystine, L-cysteic acid, L-aspartic acid, L-glutamic acid, S-(carboxymethyl)-L-cysteine, 4-aminobutyric acid, L-asparagine, L-glutamine, azaserine, L-arginine, L-canavanine, L-citruline, δ-hydroxy-L-lysine, creatine, L-kynurenine, L-histidine, 1-methyl-L-histidine, 3-methyl-L-histidine, ergothioneine, L-tryptophan, actinomycin C1, apamin, angiotensin I, angiotensin II, and antipain.

(Corrosion inhibitor)

The polishing liquid according to the embodiment of the present invention may contain a corrosion inhibitor

capable of preventing corrosion of a metal surface which may be present on the surface of an object to be polished. The corrosion inhibitor is preferably a heteroaromatic ring compound that has three or more nitrogen atoms in the molecule and has a heterocyclic structure. It is also preferable that the three or more nitrogen atoms are elements constituting a heteroaromatic ring. Examples of the preferred corrosion inhibitor include benzotriazole and benzotriazole which may have a substituent.

Specific examples of the corrosion inhibitor include benzotriazole, 1,2,3-benzotriazole, 5,6-dimethyl-1,2,3-benzotriazole, 1-(1,2-dicarboxyethyl)benzotriazole, 1-[N,N-bis(hydroxyethyl)aminomethyl]benzotriazole, and 1-(hydroxymethyl)benzotriazole. Above all, the corrosion inhibitor preferably contains one or more selected from the group consisting of 1,2,3-benzotriazole, 5,6-dimethyl-1,2,3-benzotriazole, 1-(1,2-dicarboxyethyl)benzotriazole, 1-[N,N-bis(hydroxyethyl)aminomethyl]benzotriazole, and 1-(hydroxymethyl)benzotriazole.

The content of the corrosion inhibitor is preferably 0.01% to 0.2% by mass and more preferably 0.05% to 0.2% by mass with respect to the total mass of the polishing liquid.

(Chelating agent)

The polishing liquid according to the embodiment of the present invention may contain a chelating agent.

A general-purpose water softener and a related compound thereof can be used as the chelating agent. Examples thereof include nitrilotriacetic acid, diethylenetriaminepentaacetic acid, ethylenediaminetetraacetic acid, N,N,N-aminotrimethylenephosphonic acid, ethylenediamine-N,N,N',N'-tetramethylenesulfonic acid, transcyclohexanediaminetetraacetic acid, 1,2-diaminopropanetetraacetic acid, glycol ether diamine tetraacetic acid, ethylenediamine orthohydroxyphenylacetic acid, ethylenediaminedisuccinic acid (SS form), N-(2-carboxylate ethyl)-L-aspartic acid, β-alanine diacetic acid, 2-phosphonobutane-1,2,4-tricarboxylic acid, N,N'-bis(2-hydroxybenzyl)ethylenediamine-N,N'-diacetic acid, and 1,2-dihydroxybenzene-4,6-disulfonic acid.

Two or more types of chelating agents may be used in combination.

The content of the chelating agent is preferably 0.0003 to 0.07 mol with respect to 1 L of the polishing liquid.

It is preferable that the polishing liquid according to the embodiment of the present invention has a low content of components other than the foregoing components.

For example, the polishing liquid according to the embodiment of the present invention preferably has a low content of metal ions.

In addition, it is preferable that the polishing liquid according to the embodiment of the present invention has a low content of coarse particles (for example, particles having a size of 0.1 μm or more).

[pH of polishing liquid]

The pH of the polishing liquid according to the embodiment of the present invention is preferably 2.5 to 5.0 and more preferably 3.5 to 4.5.

The pH of the polishing liquid can be adjusted by adding the above-mentioned pH adjuster.

The pH of the polishing liquid is measured by a method based on JIS Z8802-1984, using a known pH meter. The measurement temperature is 25°C.

<Manufacturing method of polishing liquid>

Hereinafter, the manufacturing of the polishing liquid according to the embodiment of the present invention will be described in detail.

[Liquid preparation method]

The method for preparing the polishing liquid according to the embodiment of the present invention is not particularly limited. For example, the polishing liquid can be manufactured by mixing the above-mentioned components to prepare a polishing liquid. The order and timing of mixing the above-mentioned components are not particularly limited. For example, colloidal silica may be mixed after mixing an organic acid and hypophosphorous acid in water, or an organic acid and hypophosphorous acid may be mixed into a solution of colloidal silica dispersed in water.

In a case of mixing each component, each component may be mixed all at once, or may be mixed in multiple batches. As each component to be mixed, a solid component may be used or an aqueous solution may be used.

In addition, a polishing liquid may be prepared by preparing a concentrated solution having a low content of water and mixing water with the concentrated solution at the time of use.

A stirring device and a stirring method used for the mixing are not particularly limited, and known devices and methods may be used. Examples of a stirrer include an industrial mixer, a portable stirrer, a mechanical stirrer, and a

magnetic stirrer.

The temperature for the mixing of each component in the preparation of the polishing liquid, the purification treatment which will be described later, and the storage of the manufactured polishing liquid is preferably 40°C or lower and more preferably 30°C or lower. The lower limit of the storage temperature is not particularly limited and is preferably 5°C or higher and more preferably 10°C or higher.

[Purification treatment]

Any one or more of the components contained in the polishing liquid may be subjected to a purification treatment in advance. The purification treatment is not particularly limited, and examples thereof include known methods such as distillation, ion exchange, and filtration.

The degree of purification is not particularly limited, but for example, it is preferable to carry out the purification until the purity of the component is 99% by mass or more, and it is more preferable to carry out the purification until the purity of the component is 99.9% by mass or more.

Examples of a specific method of the purification treatment include a method of passing a raw material of a component through an ion exchange resin, a reverse osmosis membrane (RO membrane), or the like, distillation of a raw material of a component, and filtering, which will be described later, of a raw material of a component.

The purification treatment may be carried out by a combination of a plurality of the above-mentioned purification methods. For example, a component may be subjected to primary purification of passing the component through an RO membrane, and then secondary purification of passing the component through a purification device consisting of a cation exchange resin, an anion exchange resin, or a mixed bed type ion exchange resin.

In addition, the purification treatment may be carried out a plurality of times.

The filter used for filtering is not particularly limited as long as it has been used in the related art for filtration purposes and the like. Examples of such a filter include filters consisting of a fluorine-based resin such as polytetrafluoroethylene (PTFE) or tetrafluoroethylene perfluoroalkyl vinyl ether copolymer (PFA), a polyamide-based resin such as nylon, and a polyolefin resin (including a high density or ultra high molecular weight polyolefin resin) such as polyethylene or polypropylene (PP). Among these materials, a material selected from the group consisting of polyethylene, polypropylene (including high density polypropylene), a fluorine-based resin (including PTFE and PFA), and a polyamide-based resin (including nylon) is preferable, and a filter consisting of a fluorine-based resin is more preferable.

The critical surface tension of the filter is preferably 70 to 95 mN/m and more preferably 75 to 85 mN/m. The value of the critical surface tension of the filter is a nominal value of the manufacturer.

The pore diameter of the filter is preferably 2 to 20 nm and more preferably 2 to 15 nm. With regard to the pore diameter of the filter herein, reference can be made to a nominal value of the filter manufacturer.

Filtering may be carried out only once or may be carried out twice or more. In a case where the filtering is carried out twice or more, the filters used may be the same as or different from each other.

In addition, the temperature during the filtering is preferably room temperature (25°C) or lower, more preferably 23°C or lower, and still more preferably 20°C or lower. The lower limit of the temperature is preferably 0°C or higher, more preferably 5°C or higher, and still more preferably 10°C or higher.

[Container]

Any container can be filled with the polishing liquid for storage, transportation, and use as long as corrosiveness or the like is not a problem.

The container is preferably a container for semiconductor applications which has a high degree of internal cleanliness and in which elution of impurities from an interior wall of an accommodating portion of the container into the polishing liquid is suppressed. Examples of such a container include various containers commercially available as a container for a semiconductor chemical liquid. Examples of the commercially available container include, but are not limited to, "CLEAN BOTTLE" series (manufactured by Aicello Chemical Co., Ltd.) and "PURE BOTTLE" (manufactured by Kodama Plastics Co., Ltd.).

The container for accommodating the polishing liquid is preferably a container in which a liquid contact portion that comes into contact with the polishing liquid, such as the interior wall of the accommodating portion, is formed of a fluorine-based resin (perfluororesin) or is formed of a metal which has been subjected to a rust prevention treatment and/or a metal elution prevention treatment.

The interior wall of the container is preferably formed of a resin or a metal which has been subjected to a rust prevention treatment and a metal elution prevention treatment. Examples of the resin include one or more resins selected from the group consisting of a polyethylene resin, a polypropylene resin, and a polyethylene-polypropylene resin, as well as resins different from these resins, which will be described later. Examples of the metal which has been subjected to a rust prevention treatment and a metal elution prevention treatment include stainless steel, Hastelloy, Inconel, and Monel.

As the above-mentioned different resins, a fluorine-based resin (perfluororesin) is preferable. Using a container whose interior wall is formed of a fluorine-based resin makes it possible to further suppress the occurrence of a problem of elution of an ethylene or propylene oligomer as compared with using a container whose interior wall is formed of a polyethylene resin, a polypropylene resin, or a polyethylene-polypropylene resin.

Specific examples of such a container whose interior wall is formed of a fluorine-based resin include a FluoroPure PFA composite drum manufactured by Entegris, Inc. In addition, the containers described on page 4 of JP1991-502677A (JP-H03-502677A), page 3 of WO2004/016526A, pages 9 and 16 of WO99/46309A, and the like can also be used.

In addition, quartz and an electropolished metal material (that is, a metal material subjected to electropolishing) in addition to the above-mentioned fluorine-based resin are also preferably used for the interior wall of the container.

The metal material used in the manufacture of the electropolished metal material is preferably a metal material that contains at least one selected from the group consisting of chromium and nickel and has a total content of chromium and nickel of more than 25% by mass with respect to the total mass of the metal material, examples of which include stainless steel and a nickel-chromium alloy.

The total content of chromium and nickel in the metal material is more preferably 30% by mass or more with respect to the total mass of the metal material.

The upper limit value of the total content of chromium and nickel in the metal material is not particularly limited, and is preferably 90% by mass or less.

The method for electropolishing a metal material is not particularly limited, and any known method can be used. For example, the methods described in paragraphs [0011] to [0014] of JP2015-227501A and paragraphs [0036] to [0042] of JP2008-264929A can be used.

It is preferable that the inside of these containers is cleaned before being filled with the polishing liquid. A liquid used for cleaning preferably has a reduced amount of metal impurities in the liquid. The polishing liquid may be bottled in a container such as a gallon bottle or a quart bottle after manufacture, and then transported and stored.

The inside of the container may be purged with an inert gas (such as nitrogen or argon) having a purity of 99.99995% by volume or more for the purpose of preventing changes in the components in the polishing liquid during storage. In particular, a gas having a low moisture content is preferable. In addition, during transportation and storage, the temperature may be at a normal temperature, but the temperature may be controlled in a range of -20°C to 20°C to prevent deterioration.

A proportion of a void volume other than the polishing liquid in the container, that is, a void ratio of the container is preferably 1% to 30% by volume, more preferably 3% to 20% by volume, and still more preferably 5% to 15% by volume.

[Handling environment]

It is preferable that the handling including manufacturing of the polishing liquid, opening and cleaning of the container, filling of the polishing liquid, and the like, the treatment analysis, and the measurement are all carried out in a clean room. The clean room preferably satisfies the 14644-1 clean room standards. The clean room preferably satisfies any of International Organization for Standardization (ISO) class 1, ISO class 2, ISO class 3, or ISO class 4, more preferably ISO class 1 or ISO class 2, and still more preferably ISO class 1.

<Applications of polishing liquid and polishing method>

The polishing liquid is used in a chemical mechanical polishing (CMP) treatment. Above all, the polishing liquid is preferably used in a flattening step in a case of producing a semiconductor integrated circuit.

Hereinafter, the details will be described.

[Polishing target]

An object to be subjected to the CMP treatment, that is, an object to be polished, preferably has a member containing silicon nitride. The object to be polished may have a member other than the member containing silicon nitride, and may have, for example, a member containing at least one silicon-based compound selected from the group consisting of polysilicon, modified polysilicon, silicon oxide, silicon carbide, and silicon carbide oxide. The "polysilicon" refers to polycrystalline silicon, and the "modified polysilicon" includes silicon obtained by doping polysilicon with an impurity element such as B or P. The silicon-based compound is preferably polysilicon or modified polysilicon and more preferably polysilicon.

A more specific aspect of the object to be polished includes a substrate having a member containing silicon nitride and a member containing the above-mentioned silicon-based compound as an electrode material. Such an object to be polished is suitably used in a case where a gate electrode is formed in a semiconductor integrated circuit.

A still more specific aspect of the object to be polished as described above includes an aspect having a first layer

containing silicon nitride, and a second layer containing at least one silicon-based compound selected from the group consisting of polysilicon, modified polysilicon, silicon oxide, silicon carbide, and silicon carbide oxide.

The manufacturing method of the object to be polished according to the above-mentioned aspect is not particularly limited, and for example, the object to be polished can be manufactured by the following procedure.

First, a layer consisting of silicon oxide is formed on the surface of a substrate (for example, a silicon wafer). A recessed portion is formed in the layer consisting of silicon oxide by etching or the like, and a first layer consisting of silicon nitride is laminated on the entire surface of the layer consisting of silicon oxide for the purpose of a polishing stop layer or an etching stop layer. A laminate is obtained in which a second layer consisting of polysilicon is laminated to cover the first layer and fill the recessed portion formed in the formed layer consisting of silicon oxide on the substrate on which the first layer is laminated. In a case where the laminate is subjected to a polishing treatment and the second layer consisting of polysilicon is polished to expose the first layer, the object to be polished of the above-mentioned aspect can be obtained. The polishing treatment for the laminate is preferably a polishing treatment in which the polishing rate for the first layer is low and the polishing rate for the second layer is high.

The layer consisting of silicon oxide may also correspond to the second layer, and the layer consisting of silicon oxide may be a layer consisting of silicon carbide or silicon carbide oxide. In addition, the second layer consisting of polysilicon may be a layer consisting of modified polysilicon.

Further, it is also preferable that the object to be polished, which is manufactured by the above-mentioned procedure, is subjected to a CMP treatment from the first layer side using the polishing liquid according to the embodiment of the present invention to carry out a flattening treatment. In the object to be polished which has been subjected to the flattening treatment, a structure is formed in which the first layer formed in a portion other than the recessed portion of the layer consisting of silicon oxide is removed, the second layer consisting of silicon oxide and polysilicon is flattened, and the polysilicon layer is embedded in the recessed portion of the layer consisting of silicon oxide.

A gate electrode consisting of polysilicon or modified polysilicon can be formed by subjecting the object to be polished, which has been subjected to the flattening treatment using the polishing liquid according to the embodiment of the present invention, to processing by etching or the like to have a desired shape.

In a case where polishing is carried out using the polishing liquid according to the embodiment of the present invention, the polishing rate of the member containing silicon nitride, that is, the first layer can be made higher than the polishing rate of the member containing a silicon-based compound, that is, the second layer. That is, the polishing liquid according to the embodiment of the present invention can selectively polish the member containing silicon nitride.

Therefore, even in a case where the formation of a gate electrode containing polysilicon or modified polysilicon is carried out by CMP in the above-mentioned procedure, the gate electrode is not over-polished, and a layer containing silicon nitride that requires rapid polishing can be quickly polished.

In a case where a wafer is used as the substrate of the object to be polished, the diameter of the wafer is preferably 200 mm or more and more preferably 300 mm or more.

[Polishing method]

The polishing method using the polishing liquid according to the embodiment of the present invention will be described.

In the polishing method using the polishing liquid according to the embodiment of the present invention, the polishing liquid is supplied to a polishing pad on a polishing platen, the polishing platen is rotated, and the polishing pad and a surface to be polished of an object to be polished are brought into contact and moved relative to each other so that polishing is carried out.

As the device used for polishing, a general polishing device having a holder for holding an object to be polished having a surface to be polished (for example, an object to be polished described in the section of [Polishing target]), and a polishing platen with a polishing pad attached (equipped with a motor or the like with a rotation speed being changeable) can be used. The polishing pad is not particularly limited, and a common nonwoven fabric, a foamed polyurethane, a porous fluororesin, or the like can be used.

In addition, although there are no restrictions on the polishing conditions, the rotation speed of the polishing platen is preferably a low rotation speed of 200 rpm or less so that the object to be polished does not fly out. It is noted that "rpm" is an abbreviation for "rotation per minute" and represents a rotation per minute.

A pressing pressure of the object to be polished having a surface to be polished (a film to be polished) against the polishing pad is preferably 0.68 to 34.5 kPa. From the viewpoint of satisfying in-plane uniformity of the polishing rate and flatness of the pattern, the pressing pressure of the object to be polished is more preferably 3.40 to 20.7 kPa.

During the polishing, the polishing liquid is continuously supplied to the polishing pad. The supply method is not particularly limited, and the polishing liquid may be fed using a pump or the like.

A supply rate of the polishing liquid is preferably 10 to 1,000 mL/min. From the viewpoint of satisfying in-plane uniformity of the polishing rate and flatness of the pattern, the supply rate of the polishing liquid is more preferably 170 to

800 mL/min.

The object to be polished which has been subjected to polishing may be dried after cleaning the object to be polished with running water or the like, and removing liquid droplets from the object to be polished by spin drying or the like.

The polishing liquid may be used in such a manner that each of components contained in the polishing liquid is separately supplied to the polishing pad in a state where the components are divided into two or more constituent components, and the supplied components are mixed in the polishing pad.

The polishing pad may be a non-foamed structure pad or a foamed structure pad. The foamed structure pad includes a closed cell foam (dry foam type), an open cell foam (wet foam type), a two-layer composite (laminated type), and the like, among which a two-layer composite (laminated type) is preferable. The foaming may be uniform or non-uniform.

In addition, the material constituting the polishing pad may be soft or hard, and in the laminated type, it is preferable to use materials having different hardness for each layer. Specific examples of materials include nonwoven fabric, artificial leather, polyamide, polyurethane, polyester, and polycarbonate. In addition, the surface that comes into contact with the surface to be polished may be processed with lattice grooves, holes, concentric grooves, spiral grooves, or the like.

Further, the polishing pad may contain abrasive grains (for example, ceria, silica, alumina, and resin particles) commonly used for polishing.

The device that carries out the polishing method using the polishing liquid according to the embodiment of the present invention is not particularly limited, and examples thereof include MA-300D (Musashino Denshi, Inc.), Mirra Mesa CMP and Reflexion CMP (Applied Materials, Inc.), FREX 200 and FREX 300 (Ebara Corporation), NPS3301 and NPS2301 (Nikon Corporation), A-FP-310A and A-FP-210A (Tokyo Seimitsu Co., Ltd.), 2300 TERES (Lam Research Corporation), and Momentum (SpeedFam-IPEC, Inc.).

Examples

Hereinafter, the present invention will be described in more detail with reference to Examples.

The materials, amounts of materials used, proportions, treatment details, treatment procedure, and the like shown in Examples given below can be appropriately modified without departing from the scope of the present invention. Accordingly, the scope of the present invention should not be construed as being limited to the Examples described below.

<Preparation of polishing liquid>

Each component and water were mixed to have the contents shown in the tables which will be given later to prepare polishing liquids used in each Example and each Comparative Example. Therefore, the remainder of each polishing liquid is water. Except for Example 56, the pH of the polishing liquid was adjusted to the pH shown in the table by adding ammonia. The pH of the polishing liquid of Example 56 was adjusted to the pH shown in the table by adding potassium hydroxide (KOH).

The meaning of the notation of each component in the tables which will be given later is as follows.

[Colloidal silica]

PL05: PL-05 (colloidal silica manufactured by Fuso Chemical Co., Ltd., average primary particle diameter: 5 nm, average secondary particle diameter: 10 nm)
PL1: PL-1 (colloidal silica manufactured by Fuso Chemical Co., Ltd., average primary particle diameter: 12 nm, average secondary particle diameter: 25 nm)
PL2: PL-2 (colloidal silica manufactured by Fuso Chemical Co., Ltd., average primary particle diameter: 25 nm, average secondary particle diameter: 50 nm)
PL3: PL-3 (colloidal silica manufactured by Fuso Chemical Co., Ltd., average primary particle diameter: 35 nm, average secondary particle diameter: 70 nm)

[Organic acid]

B1: organic acid B1 given above
B2: organic acid B2 given above
B3: organic acid B3 given above

B4: organic acid B4 given above
B5: organic acid B5 given above
B6: organic acid B6 given above
B7: organic acid B7 given above
B8: organic acid B8 given above
B9: organic acid B9 given above
B10: organic acid B10 given above
B11: organic acid B11 given above
B12: organic acid B12 given above
B13: organic acid B13 given above
B14: organic acid B14 given above
B15: organic acid B15 given above

[Surfactant]

P1: alkyl ether sulfonic acid (number of carbon atoms in alkyl group: 12)
P2: alkylbenzene sulfonic acid (number of carbon atoms in alkyl group: 12)
P3: alkyl diphenyl ether sulfonic acid (number of carbon atoms in alkyl group: 12)
P4: alkyl diphenyl ether sulfonic acid (number of carbon atoms in alkyl group: mixture of 12 and 13)
P5: mixture of alkyl diphenyl ether sulfonic acid (number of carbon atoms in alkyl group: 12) and alkyl diphenyl ether trisulfonic acid (number of carbon atoms in alkyl group: 12)

With regard to P4, alkyl diphenyl ether sulfonic acid having an alkyl group having 12 carbon atoms and alkyl diphenyl ether sulfonic acid having an alkyl group having 13 carbon atoms were mixed in the ratio shown in the table which will be given later.

With regard to P5, alkyl diphenyl ether sulfonic acid and alkyl diphenyl ether trisulfonic acid were mixed in the ratio shown in the table which will be given later.

In a case where a plurality of types of surfactants were mixed, the total content thereof was adjusted to be the content shown in the table which will be given later.

<Polishing test>

An object to be polished was polished using each of the polishing liquids under the conditions shown below.

[Polishing device and conditions]

"FREX 300II" manufactured by Ebara Corporation was used as the polishing device.

Polishing was carried out under the following conditions while supplying a polishing liquid.

Table rotation speed: 80 rpm
Head rotation speed: 78 rpm
Polishing pressure: 12 kPa
Polishing pad: IC1400 manufactured by Rodel Nitta Company
Polishing liquid supply rate: 250 mL/min

[Object to be polished]

The following objects to be polished were used as the object to be polished.

Object 1 to be polished: 12-inch silicon wafer with a 300 nm silicon nitride layer ($Si_3N_4$) formed on the surface
Object 2 to be polished: 12-inch silicon wafer with a 500 nm polysilicon layer formed on the surface
Object 3 to be polished: wafer with a silicon nitride layer and a polysilicon layer exposed on the surface in a line-and-space pattern

The object 3 to be polished was produced by the following method.

First, a wafer with a pattern having a line portion and a space portion (SEMATECH 754 TEG, line/space: 10

μm/10 μm) was prepared. This wafer had an insulating layer formed of tetraethoxysilane (TEOS) and a pattern formed on the insulating layer.

First, a silicon nitride layer was deposited on the wafer with a pattern to a thickness of 50 nm. Next, a polysilicon layer was formed to fill a space portion of the pattern with polysilicon. Specifically, as shown in Fig. 1, a laminate 10 having a silicon nitride layer 16 and a polysilicon layer 18 in this order on a wafer 12 with a pattern having a line portion 14 consisting of an insulating layer was obtained. As shown in Fig. 1, due to the formation of a polysilicon layer, the silicon nitride layer 16 disposed on the line portion 14 was covered with the polysilicon layer 18.

After the formation of the polysilicon layer, the polysilicon layer was polished using FSL1531 (polishing liquid manufactured by FUJIFILM Corporation) under the above-mentioned polishing conditions. The polishing ended at a point where the silicon nitride layer was exposed, and an end point detection device of the polishing device was used to detect the end point. As a result of the polishing described above, the silicon nitride layer disposed in the line portion was exposed, and as a result, a wafer (an object 3 to be polished) was obtained in which the silicon nitride layer was disposed on the surface of the line portion and the space portion was filled with polysilicon.

The dishing value of polysilicon in the object 3 to be polished was evaluated by AFM, and in a case where the average value was obtained at 10 points, the value was 7 nm.

[Measurement of polishing rate]

The object 1 to be polished was polished using each of the polishing liquids under the above-mentioned polishing conditions, and the polishing rate was calculated according to the following expression from the layer thickness of the silicon nitride layer before and after polishing. The layer thickness was measured by a noncontact film thickness measuring instrument FE-33 (manufactured by Otsuka Electronics Co., Ltd.).

Polishing rate (nm/min) = (layer thickness (nm) before polishing - layer thickness (nm) after polishing)/polishing time (min)

The film thickness was measured at 49 points in a diameter direction, the polishing rate at each point was calculated based on the film thickness at the 49 points, and the average value of the calculated values was described as the polishing rate in the table which will be given later.

Further, the polishing was carried out 10 times under the above-mentioned conditions, the standard deviation σ (nm/min) of the polishing rate was determined, and the variation in polishing rate of the silicon nitride was calculated as 3σ (nm/min).

The polishing rate and the variation in polishing rate of the polysilicon layer were calculated using the object 2 to be polished in the same manner as the polishing rate of the silicon nitride layer.

The polishing rate shown in the tables which will be given later shows an average polishing rate in a case where the above-mentioned polishing was carried out 10 times.

[Evaluation of dishing]

In some Examples, the object 3 to be polished was used to evaluate the dishing value of polysilicon in a case where each polishing liquid was used. Specifically, the object 3 to be polished was polished for 30 seconds under the above-mentioned conditions using each polishing liquid. After polishing, the dishing value of polysilicon was evaluated in the same manner as the evaluation of the dishing value before polishing.

[Polysilicon residue evaluation]

In some Examples, polysilicon residue evaluation was carried out using a defect inspection device (ComPlus II). Specifically, a polysilicon bare wafer (12 inches) was polished for 60 seconds under the above-mentioned conditions using each polishing liquid, cleaned with 100:1 diluted hydrofluoric acid, and rinsed with water, after which the number of residues on the entire surface of the wafer was evaluated. From the number of residues, the polysilicon residue was evaluated based on the following evaluation standards.

A: The number of residues was less than 50
B: The number of residues was 50 or more and less than 100
C: The number of residues was 100 or more

<Results>

Tables 1 and 2 show the composition and evaluation results of each polishing liquid.

With regard to Examples 59 to 78, the values in the column of "phosphonic acid/organic acid", the column of "hypophosphorous acid/organic acid", the column of "phosphoric acid/organic acid", the column of "phosphoric acid/-hypophosphorous acid", and the column of "phosphoric acid/phosphonic acid" are the same as the values in Example 54, so the description thereof will not be repeated.

[Table 1]

| Table 1-1 | Colloidal silica (% by mass) | | Organic acid (% by mass) | | Hypophosphorous acid (% by mass) | Phosphonic acid (% by mass) | Phosphoric acid (% by mass) | pH | Hypophosphorous acid/organic acid (mass ratio) | Phosphonic acid/organic acid (mass ratio) | Phosphoric acid/organic acid (mass ratio) | Phosphoric acid/hypophosphorous acid (mass ratio) | Phosphoric acid/phosphonic acid (mass ratio) | pH adjuster | Polishing rate of silicon nitride (nm/min) | Variation in polishing rate of silicon nitride (nm/min) | Polishing rate of polysilicon (nm/min) | Variation in polishing rate of polysilicon (nm/min) |
|---|---|---|---|---|---|---|---|---|---|---|---|---|---|---|---|---|---|---|
| Example 1 | PL2 | 2 | B10 | 5 | 8.0E-04 | - | - | 4.0 | 1.6E-04 | - | - | - | - | NH3 | 83 | 2.1 | 23 | 3.6 |
| Example 2 | PL2 | 2 | B13 | 5 | 1.0E-03 | - | - | 4.0 | 2.0E-04 | - | - | - | - | NH3 | 78 | 2.5 | 21 | 4.3 |
| Example 3 | PL2 | 2 | B15 | 5 | 6.5E-04 | - | - | 4.0 | 1.3E-04 | - | - | - | - | NH3 | 81 | 2.9 | 25 | 5.0 |
| Example 4 | PL2 | 2 | B1 | 5 | 6.5E-04 | - | - | 4.0 | 1.3E-04 | - | - | - | - | NH3 | 83 | 3.2 | 29 | 5.5 |
| Example 5 | PL2 | 2 | B2 | 5 | 1.5E-03 | - | - | 4.0 | 3.0E-04 | - | - | - | - | NH3 | 78 | 3.4 | 27 | 5.2 |
| Example 6 | PL2 | 2 | B3 | 5 | 6.0E-04 | - | - | 4.0 | 1.2E-04 | - | - | - | - | NH3 | 81 | 3.3 | 25 | 5.4 |
| Example 7 | PL2 | 2 | B4 | 5 | 7.0E-04 | - | - | 4.0 | 1.4E-04 | - | - | - | - | NH3 | 83 | 3.2 | 26 | 5.8 |
| Example 8 | PL2 | 2 | B5 | 5 | 1.5E-03 | - | - | 4.0 | 3.0E-04 | - | - | - | - | NH3 | 78 | 3.2 | 28 | 5.3 |
| Example 9 | PL2 | 2 | B6 | 5 | 7.5E-04 | - | - | 4.0 | 1.5E-04 | - | - | - | - | NH3 | 81 | 3.5 | 28 | 5.2 |
| Example 10 | PL2 | 2 | B7 | 5 | 8.5E-04 | - | - | 4.0 | 1.7E-04 | - | - | - | - | NH3 | 83 | 3.2 | 29 | 5.1 |
| Example 11 | PL2 | 2 | B8 | 5 | 1.0E-03 | - | - | 4.0 | 2.0E-04 | - | - | - | - | NH3 | 78 | 3.1 | 27 | 5.3 |
| Example 12 | PL2 | 2 | B9 | 5 | 8.0E-04 | - | - | 4.0 | 1.6E-04 | - | - | - | - | NH3 | 81 | 3.2 | 28 | 5.6 |
| Example 13 | PL2 | 2 | B11 | 5 | 1.1E-03 | - | - | 4.0 | 2.2E-04 | - | - | - | - | NH3 | 78 | 3.4 | 27 | 5.7 |
| Example 14 | PL2 | 2 | B12 | 5 | 9.0E-04 | - | - | 4.0 | 1.8E-04 | - | - | - | - | NH3 | 81 | 3.3 | 27 | 5.5 |
| Example 15 | PL2 | 2 | B14 | 5 | 3.5E-03 | - | - | 4.0 | 7.0E-04 | - | - | - | - | NH3 | 78 | 3.5 | 29 | 5.4 |
| Example 16 | PL2 | 2 | B10 | 5 | 5.0E-09 | - | - | 4.0 | 1.0E-09 | - | - | - | - | NH3 | 83 | 3.1 | 24 | 6.5 |
| Example 17 | PL2 | 2 | B10 | 5 | 1.0E-08 | - | - | 4.0 | 2.0E-09 | - | - | - | - | NH3 | 83 | 2.8 | 23 | 4.8 |
| Example 18 | PL2 | 2 | B10 | 5 | 5.0E-08 | - | - | 4.0 | 1.0E-08 | - | - | - | - | NH3 | 78 | 2.1 | 22 | 3.6 |
| Example 19 | PL2 | 2 | B10 | 5 | 2.3E-08 | - | - | 4.0 | 4.5E-09 | - | - | - | - | NH3 | 78 | 2.3 | 21 | 3.9 |
| Example 20 | PL2 | 2 | B10 | 5 | 1.0E-05 | - | - | 4.0 | 2.0E-06 | - | - | - | - | NH3 | 78 | 2.2 | 20 | 3.8 |
| Example 21 | PL2 | 2 | B10 | 5 | 5.0E-04 | - | - | 4.0 | 1.0E-04 | - | - | - | - | NH3 | 78 | 2.2 | 25 | 3.8 |
| Example 22 | PL2 | 2 | B10 | 5 | 1.0E-03 | - | - | 4.0 | 2.0E-04 | - | - | - | - | NH3 | 78 | 2.6 | 26 | 4.5 |
| Example 23 | PL2 | 2 | B10 | 5 | 7.5E-01 | - | - | 4.0 | 1.5E-01 | - | - | - | - | NH3 | 78 | 2.8 | 24 | 6.4 |
| Example 24 | PL2 | 2 | B10 | 5 | 8.0E-04 | 2.4E-10 | - | 4.0 | 1.6E-04 | 4.8E-11 | - | - | - | NH3 | 83 | 2.8 | 23 | 4.8 |
| Example 25 | PL2 | 2 | B10 | 5 | 4.0E-04 | 3.1E-09 | - | 4.0 | 8.0E-05 | 6.2E-10 | - | - | - | NH3 | 83 | 2.6 | 23 | 4.5 |
| Example 26 | PL2 | 2 | B10 | 5 | 4.6E-06 | 5.1E-09 | - | 4.0 | 9.2E-07 | 1.0E-09 | - | - | - | NH3 | 83 | 2.4 | 22 | 4.1 |
| Example 27 | PL2 | 2 | B10 | 5 | 7.3E-04 | 1.2E-05 | - | 4.0 | 1.5E-04 | 2.3E-06 | - | - | - | NH3 | 83 | 2.3 | 21 | 3.9 |
| Example 28 | PL2 | 2 | B10 | 5 | 4.0E-03 | 5.0E-04 | - | 4.0 | 8.0E-04 | 1.0E-04 | - | - | - | NH3 | 83 | 2.2 | 25 | 3.8 |
| Example 29 | PL2 | 2 | B10 | 5 | 5.0E-05 | 1.6E-02 | - | 4.0 | 1.0E-05 | 3.1E-03 | - | - | - | NH3 | 83 | 2.8 | 24 | 6.1 |
| Example 30 | PL1 | 2 | B10 | 5 | 6.0E-04 | 7.2E-08 | - | 4.0 | 1.2E-04 | 1.4E-08 | - | - | - | NH3 | 63 | 2.0 | 18 | 3.4 |

[Table 2]

| Table 1-2 | Colloidal silica (% by mass) | | Organic acid (% by mass) | | Hypophosphorous acid (% by mass) | Phosphonic acid (% by mass) | Phosphoric acid (% by mass) | pH | Hypophosphorous acid/organic acid (mass ratio) | Phosphonic acid/organic acid (mass ratio) | Phosphoric acid/organic acid (mass ratio) | Phosphoric acid/hypophosphorous acid (mass ratio) | Phosphoric acid/phosphonic acid (mass ratio) | pH adjuster | Polishing rate of silicon nitride (nm/min) | Variation in polishing rate of silicon nitride (nm/min) | Polishing rate of polysilicon (nm/min) | Variation in polishing rate of polysilicon (nm/min) |
|---|---|---|---|---|---|---|---|---|---|---|---|---|---|---|---|---|---|---|
| Example 31 | PL3 | 2 | B10 | 5 | 6.0E-04 | 7.2E-08 | - | 4.0 | 1.2E-04 | 1.4E-08 | - | - | - | NH3 | 85 | 2.0 | 36 | 3.4 |
| Example 32 | PL05 | 2 | B10 | 5 | 7.0E-04 | 9.8E-08 | - | 4.0 | 1.4E-04 | 2.0E-08 | - | - | - | NH3 | 57 | 2.1 | 11 | 3.6 |
| Example 33 | PL2 | 2 | B10 | 5 | 7.5E-04 | 1.1E-07 | - | 2.5 | 1.5E-04 | 2.3E-08 | - | - | - | NH3 | 72 | 1.8 | 20 | 3.1 |
| Example 34 | PL2 | 2 | B10 | 5 | 8.5E-04 | 1.4E-07 | - | 3.5 | 1.7E-04 | 2.9E-08 | - | - | - | NH3 | 70 | 2.2 | 25 | 3.8 |
| Example 35 | PL2 | 2 | B10 | 5 | 7.5E-04 | 1.1E-07 | - | 4.5 | 1.5E-04 | 2.3E-08 | - | - | - | NH3 | 72 | 1.8 | 26 | 3.1 |
| Example 36 | PL2 | 2 | B10 | 5 | 6.0E-04 | 7.2E-08 | - | 5.0 | 1.2E-04 | 1.4E-08 | - | - | - | NH3 | 68 | 2.4 | 30 | 4.1 |
| Example 37 | PL2 | 0.5 | B10 | 5 | 4.0E-04 | 3.2E-08 | - | 4.0 | 8.0E-05 | 6.4E-09 | - | - | - | NH3 | 26 | 2.8 | 26 | 4.8 |
| Example 38 | PL2 | 1 | B10 | 5 | 7.0E-04 | 9.8E-08 | - | 4.0 | 1.4E-04 | 2.0E-08 | - | - | - | NH3 | 42 | 2.2 | 42 | 3.8 |
| Example 39 | PL2 | 5 | B10 | 5 | 8.5E-04 | 1.4E-07 | - | 4.0 | 1.7E-04 | 2.9E-08 | - | - | - | NH3 | 106 | 2.3 | 35 | 3.9 |
| Example 40 | PL2 | 10 | B10 | 5 | 6.5E-04 | 8.5E-08 | - | 4.0 | 1.3E-04 | 1.7E-08 | - | - | - | NH3 | 145 | 2.5 | 34 | 4.3 |
| Example 41 | PL2 | 2 | B10 | 0.05 | 1.1E-05 | 2.2E-09 | - | 4.0 | 2.1E-04 | 4.4E-08 | - | - | - | NH3 | 51 | 2.4 | 27 | 4.1 |
| Example 42 | PL2 | 2 | B10 | 0.1 | 1.0E-05 | 1.0E-09 | - | 4.0 | 1.0E-04 | 1.0E-08 | - | - | - | NH3 | 58 | 2.3 | 26 | 3.9 |
| Example 43 | PL2 | 2 | B10 | 1 | 1.4E-04 | 2.0E-08 | - | 4.0 | 1.4E-04 | 2.0E-08 | - | - | - | NH3 | 63 | 2.2 | 25 | 3.8 |
| Example 44 | PL2 | 2 | B10 | 3 | 4.5E-04 | 6.8E-08 | - | 4.0 | 1.5E-04 | 2.3E-08 | - | - | - | NH3 | 68 | 2.3 | 23 | 3.9 |
| Example 45 | PL2 | 2 | B10 | 10 | 1.1E-03 | 1.2E-07 | - | 4.0 | 1.1E-04 | 1.2E-08 | - | - | - | NH3 | 70 | 2.1 | 22 | 3.6 |
| Example 46 | PL2 | 2 | B10 | 15 | 1.4E-03 | 1.2E-07 | - | 4.0 | 9.0E-05 | 8.1E-09 | - | - | - | NH3 | 69 | 2.7 | 21 | 4.6 |
| Example 47 | PL2 | 2 | B10 | 5 | 8.0E-04 | - | 5.0E-08 | 4.0 | 1.6E-04 | - | 1.0E-08 | 6.3E-05 | - | NH3 | 70 | 2.6 | 24 | 4.5 |
| Example 48 | PL2 | 2 | B10 | 5 | 8.0E-04 | - | 8.1E-08 | 4.0 | 1.6E-04 | - | 1.6E-08 | 1.0E-04 | - | NH3 | 71 | 2.5 | 25 | 4.3 |
| Example 49 | PL2 | 2 | B10 | 5 | 8.0E-04 | - | 1.3E-06 | 4.0 | 1.6E-04 | - | 2.6E-07 | 1.6E-03 | - | NH3 | 73 | 2.3 | 23 | 3.9 |
| Example 50 | PL2 | 2 | B10 | 5 | 1.0E-05 | - | 1.0E-04 | 4.0 | 2.0E-06 | - | 2.0E-05 | 1.0E+01 | - | NH3 | 72 | 2.1 | 22 | 3.6 |
| Example 51 | PL2 | 2 | B10 | 5 | 8.0E-05 | - | 1.5E-03 | 4.0 | 1.6E-05 | - | 3.0E-04 | 1.9E+01 | - | NH3 | 74 | 2.8 | 21 | 4.8 |
| Example 52 | PL2 | 2 | B10 | 5 | 8.0E-04 | 1.3E-06 | 5.0E-09 | 4.0 | 1.6E-04 | 2.6E-07 | 1.0E-09 | 6.3E-06 | 3.9E-03 | NH3 | 71 | 1.9 | 25 | 3.3 |
| Example 53 | PL2 | 2 | B10 | 5 | 8.0E-04 | 1.3E-05 | 1.3E-07 | 4.0 | 1.6E-04 | 2.6E-06 | 2.6E-08 | 1.6E-04 | 1.0E-02 | NH3 | 73 | 1.4 | 23 | 2.4 |
| Example 54 | PL2 | 2 | B10 | 5 | 8.0E-04 | 1.3E-06 | 1.3E-04 | 4.0 | 1.6E-04 | 2.5E-07 | 2.6E-05 | 1.6E-01 | 1.0E+02 | NH3 | 73 | 1.3 | 22 | 2.2 |
| Example 55 | PL2 | 2 | B10 | 5 | 8.0E-04 | 1.5E-05 | 4.5E-02 | 4.0 | 1.6E-04 | 3.0E-06 | 9.0E-03 | 5.6E+01 | 3.0E+03 | NH3 | 71 | 1.9 | 24 | 3.3 |
| Example 56 | PL2 | 2 | B10 | 5 | 8.0E-04 | 1.3E-05 | 2.5E-06 | 4.0 | 1.6E-04 | 2.6E-06 | 5.0E-07 | 3.1E-03 | 2.0E-01 | KOH | 68 | 3.5 | 31 | 6.0 |
| Example 57 | PL2 | 2 | B13 | 5 | 2.5E-06 | 1.3E-12 | 2.5E-06 | 2.0 | 5.0E-07 | 5.0E-07 | 5.0E-07 | 1.3E-06 | 2.0E+06 | NH3 | 68 | 5.1 | 26 | 8.7 |
| Example 58 | PL2 | 2 | B13 | 5 | 2.5E-06 | 1.3E-12 | 2.5E-06 | 6.0 | 5.0E-07 | 5.0E-07 | 5.0E-07 | 1.3E-06 | 2.0E+06 | NH3 | 52 | 4.9 | 24 | 8.4 |
| Comparative Example 1 | PL2 | 2 | B13 | 5 | - | - | - | 4.0 | - | - | - | - | - | NH3 | 71 | 6.8 | 25 | 11.7 |

[Table 3]

| Table 2 | Colloidal silica (% by mass) | | Organic acid (% by mass) | | Hypophosphorous acid (% by mass) | Phosphonic acid (% by mass) | Phosphoric acid (% by mass) | Sulfuric acid (% by mass) | Surfactant (% by mass) | | pH | Sulfuric acid/organic acid (mass ratio) | Sulfuric acid/surfactant (mass ratio) | Surfactant C13/C12 (mass ratio) | Surfactant trisulfonic acid/disulfonic acid (mass ratio) | pH adjuster | Polishing rate of silicon nitride (nm/min) | Variation in polishing rate of silicon nitride (nm/min) | Evaluation of dishing (nm) | Polysilicon residue |
|---|---|---|---|---|---|---|---|---|---|---|---|---|---|---|---|---|---|---|---|---|
| Example 59 | PL2 | 2 | B10 | 5 | 8.0E-04 | 1.3E-06 | 1.3E-04 | 8.4E-03 | P1 | 1.2 | 4.0 | 1.7E-03 | 7.0E-03 | - | - | NH3 | 71 | 1.8 | 25 | B |
| Example 60 | PL2 | 2 | B10 | 5 | 8.0E-04 | 1.3E-06 | 1.3E-04 | 4.8E-03 | P2 | 1.2 | 4.0 | 9.6E-04 | 4.0E-03 | - | - | NH3 | 72 | 1.7 | 23 | B |
| Example 61 | PL2 | 2 | B10 | 5 | 8.0E-04 | 1.3E-06 | 1.3E-04 | 3.5E-05 | P3 | 1.2 | 4.0 | 7.0E-06 | 2.9E-05 | - | - | NH3 | 74 | 2.5 | 21 | B |
| Example 62 | PL2 | 2 | B10 | 5 | 8.0E-04 | 1.3E-06 | 1.3E-04 | 5.0E-05 | P3 | 1.2 | 4.0 | 1.0E-05 | 4.2E-05 | - | - | NH3 | 73 | 1.8 | 20 | B |
| Example 63 | PL2 | 2 | B10 | 5 | 8.0E-04 | 1.3E-06 | 1.3E-04 | 1.5E-04 | P3 | 1.2 | 4.0 | 3.0E-05 | 1.3E-04 | - | - | NH3 | 74 | 1.9 | 19 | B |
| Example 64 | PL2 | 2 | B10 | 5 | 8.0E-04 | 1.3E-06 | 1.3E-04 | 1.0E-03 | P3 | 1.2 | 4.0 | 2.0E-04 | 8.3E-04 | - | - | NH3 | 73 | 1.7 | 18 | B |
| Example 65 | PL2 | 2 | B10 | 5 | 8.0E-04 | 1.3E-06 | 1.3E-04 | 4.5E-02 | P3 | 1.2 | 4.0 | 9.0E-03 | 3.8E-02 | - | - | NH3 | 71 | 1.5 | 22 | B |
| Example 66 | PL2 | 2 | B10 | 5 | 8.0E-04 | 1.3E-06 | 1.3E-04 | 9.5E-02 | P3 | 1.2 | 4.0 | 1.9E-02 | 7.9E-02 | - | - | NH3 | 70 | 1.6 | 18 | B |
| Example 67 | PL2 | 2 | B10 | 5 | 8.0E-04 | 1.3E-06 | 1.3E-04 | 5.5E-01 | P3 | 1.2 | 4.0 | 1.1E-01 | 4.6E-01 | - | - | NH3 | 74 | 1.5 | 19 | B |
| Example 68 | PL2 | 2 | B10 | 5 | 8.0E-04 | 1.3E-06 | 1.3E-04 | 2.0E+00 | P3 | 1.2 | 4.0 | 4.0E-01 | 1.7E+00 | - | - | NH3 | 73 | 2.6 | 21 | B |
| Example 69 | PL2 | 2 | B10 | 5 | 8.0E-04 | 1.3E-06 | 1.3E-04 | 4.5E-02 | P4 | 1.2 | 4.0 | 9.0E-03 | 3.8E-02 | 0.02 | - | NH3 | 72 | 1.4 | 16 | B |
| Example 70 | PL2 | 2 | B10 | 5 | 8.0E-04 | 1.3E-06 | 1.3E-04 | 4.5E-02 | P4 | 1.2 | 4.0 | 9.0E-03 | 3.8E-02 | 0.13 | - | NH3 | 72 | 1.4 | 15 | B |
| Example 71 | PL2 | 2 | B10 | 5 | 8.0E-04 | 1.3E-06 | 1.3E-04 | 4.5E-02 | P4 | 1.2 | 4.0 | 9.0E-03 | 3.8E-02 | 0.21 | - | NH3 | 73 | 1.4 | 15 | B |
| Example 72 | PL2 | 2 | B10 | 5 | 8.0E-04 | 1.3E-06 | 1.3E-04 | 4.5E-02 | P4 | 1.2 | 4.0 | 9.0E-03 | 3.8E-02 | 0.30 | - | NH3 | 74 | 1.4 | 14 | B |
| Example 73 | PL2 | 2 | B10 | 5 | 8.0E-04 | 1.3E-06 | 1.3E-04 | 4.5E-02 | P4 | 1.2 | 4.0 | 9.0E-03 | 3.8E-02 | 1.00 | - | NH3 | 75 | 1.4 | 14 | C |
| Example 74 | PL2 | 2 | B10 | 5 | 8.0E-04 | 1.3E-06 | 1.3E-04 | 6.0E-03 | P5 | 1.2 | 4.0 | 1.2E-03 | 5.0E-03 | 0.21 | 1.0E-05 | NH3 | 71 | 1.4 | 14 | B |
| Example 75 | PL2 | 2 | B10 | 5 | 8.0E-04 | 1.3E-06 | 1.3E-04 | 6.0E-03 | P5 | 1.2 | 4.0 | 1.2E-03 | 5.0E-03 | 0.21 | 1.0E-03 | NH3 | 75 | 1.4 | 13 | A |
| Example 76 | PL2 | 2 | B10 | 5 | 8.0E-04 | 1.3E-06 | 1.3E-04 | 6.0E-03 | P5 | 1.2 | 4.0 | 1.2E-03 | 5.0E-03 | 0.21 | 1.0E-02 | NH3 | 73 | 1.4 | 12 | A |
| Example 77 | PL2 | 2 | B10 | 5 | 8.0E-04 | 1.3E-06 | 1.3E-04 | 6.0E-03 | P5 | 1.2 | 4.0 | 1.2E-03 | 5.0E-03 | 0.21 | 1.0E-01 | NH3 | 72 | 1.4 | 11 | A |
| Example 78 | PL2 | 2 | B10 | 5 | 8.0E-04 | 1.3E-06 | 1.3E-04 | 6.0E-03 | P5 | 1.2 | 4.0 | 1.2E-03 | 5.0E-03 | 0.21 | 1.0E+00 | NH3 | 73 | 1.4 | 11 | B |

From the results shown in Tables 1 and 2, it was confirmed that the polishing liquid according to the embodiment of the present invention was excellent in the polishing rate and had a small variation in polishing rate. On the other hand, it was confirmed that the polishing liquid of Comparative Example 1, which did not contain hypophosphorous acid, had a large variation in polishing rate.

From the comparison of Examples 33 to 36 with Examples 57 and 58, it was confirmed that, in a case where the pH of the polishing liquid was 2.5 to 5.0, the variation in polishing rate was smaller.

From the comparison of Examples 38 and 39 with Examples 37 and 40, it was confirmed that, in a case where the content of the colloidal silica was 1% to 5% by mass with respect to the total mass of the polishing liquid, the variation in polishing rate was smaller.

From the comparison of Examples 1 to 3 with Examples 4 to 15, it was confirmed that, in a case where the organic acid was 1-hydroxyethane-1,1-diphosphonic acid, tris(phosphonomethyl)amine, or ethylenediaminetetramethylenephosphonic acid, the variation in polishing rate was smaller.

From the comparison of Example 1 with Examples 2 and 3, it was confirmed that, in a case where the organic acid was 1-hydroxyethane-1,1-diphosphonic acid, the variation in polishing rate was smaller.

From the comparison of Examples 17 to 22, and 28 with Examples 16 and 23, it was confirmed that, in a case where the content of hypophosphorous acid was $1.0 \times 10^{-8}$% to $5.0 \times 10^{-3}$% by mass with respect to the total mass of the polishing liquid, the variation in polishing rate was smaller.

From the comparison of Examples 18 to 22 with Examples 16, 17, and 23, it was confirmed that, in a case where the mass ratio of the content of the hypophosphorous acid to the content of the organic acid was $1.0 \times 10^{-8}$ to $2.0 \times 10^{-4}$, the variation in polishing rate was smaller.

From the comparison of Examples 25 to 28 with Examples 24 and 29, it was confirmed that, in a case where the polishing liquid further contained phosphonic acid and the content of the phosphonic acid was $1.0 \times 10^{-9}$% to $5.0 \times 10^{-4}$% by mass with respect to the total mass of the polishing liquid, the variation in polishing rate was smaller.

From the comparison of Examples 26 to 28 with Examples 24, 25, and 29, it was confirmed that, in a case where the mass ratio of the content of the phosphonic acid to the content of the organic acid was $1.0 \times 10^{-9}$ to $1.0 \times 10^{-4}$, the variation in polishing rate was smaller.

From the comparison of Examples 48 to 50 with Examples 47 and 51, it was confirmed that, in a case where the polishing liquid further contained phosphoric acid, and the mass ratio of the content of the phosphoric acid to the content of the organic acid was $1.5 \times 10^{-8}$ to $3.0 \times 10^{-5}$, the variation in polishing rate was smaller.

From the comparison of Examples 48 to 50 with Examples 47 and 51, it was confirmed that, in a case where the polishing liquid further contained phosphoric acid, and the mass ratio of the content of the phosphoric acid to the content of the hypophosphorous acid was $1.0 \times 10^{-4}$ to $1.0 \times 10^{1}$, the variation in polishing rate was smaller.

From the comparison of Examples 53 and 54 with Examples 52 and 55, it was confirmed that, in a case where the polishing liquid further contained phosphonic acid and phosphoric acid, and the mass ratio of the content of the phosphoric acid to the content of the phosphonic acid was $1.0 \times 10^{-2}$ to $1.0 \times 10^{2}$, the variation in polishing rate was smaller.

From the comparison of Example 53 with Example 56, it was confirmed that, in a case where the polishing liquid further contained ammonia, the variation in polishing rate was smaller.

From the comparison of Examples 61 to 78 with Examples 59 and 60, it was confirmed that, in a case where the surfactant contained alkyl diphenyl ether disulfonic acid or a salt thereof or a derivative of alkyl diphenyl ether disulfonic acid or a salt thereof, the results in the dishing evaluation were more excellent.

From the comparison of Examples 69 to 72 with Examples 62 to 67, and 73, it was confirmed that, in a case where the surfactant contained a first surfactant selected from the group consisting of alkyl diphenyl ether disulfonic acid having an alkyl group having 12 carbon atoms or a salt thereof, and a derivative of alkyl diphenyl ether disulfonic acid having an alkyl group having 12 carbon atoms or a salt thereof, and a second surfactant selected from the group consisting of alkyl diphenyl ether disulfonic acid having an alkyl group having 13 carbon atoms or a salt thereof, and a derivative of alkyl diphenyl ether disulfonic acid having an alkyl group having 13 carbon atoms or a salt thereof, and the mass ratio of the content of the second surfactant to the content of the first surfactant was $2.0 \times 10^{-2}$ to $3.0 \times 10^{-1}$, the variation in polishing rate was smaller, the results in the dishing evaluation were more excellent, and the amount of polysilicon residues was smaller.

From the comparison of Examples 75 to 77 with Examples 74 and 78, it was confirmed that, in a case where the polishing liquid contained alkyl diphenyl ether disulfonic acid or a salt thereof and alkyl diphenyl ether polysulfonic acid or a salt thereof, the ratio of the total content of the alkyl diphenyl ether polysulfonic acid or the salt thereof to the alkyl diphenyl ether disulfonic acid or the salt thereof was $1.0 \times 10^{-3}$ to $1.0 \times 10^{-1}$, the amount of polysilicon residues was smaller.

From the comparison of Examples 62 to 77 with Examples 61 and 68, it was confirmed that, in a case where the polishing liquid further contained sulfuric acid, and the mass ratio of the content of the sulfuric acid to the content of the organic acid was $1.0 \times 10^{-5}$ to $3.0 \times 10^{-1}$, the variation in polishing rate was smaller.

From the comparison of Examples 62 to 77 with Examples 61 and 68, it was confirmed that, in a case where the polishing liquid further contained a surfactant having a sulfonic acid group or a salt thereof and sulfuric acid, and the mass

ratio of the content of the sulfuric acid to the content of the surfactant is $3.0 \times 10^{-5}$ to $5.0 \times 10^{-1}$, the variation in polishing rate was smaller.

Explanation of References

10: laminate
12: wafer with pattern
14: line portion
16: silicon nitride layer
18: polysilicon layer

## Claims

**1.** A polishing liquid for use in chemical mechanical polishing, the polishing liquid comprising:

colloidal silica,
an organic acid having at least a phosphonic acid group or a salt thereof in a molecular structure,
hypophosphorous acid, and
water.

**2.** The polishing liquid according to claim 1,
wherein the polishing liquid has a pH of 2.5 to 5.0.

**3.** The polishing liquid according to claim 1 or 2,
wherein a content of the colloidal silica is 1% to 5% by mass with respect to a total mass of the polishing liquid.

**4.** The polishing liquid according to any one of claims 1 to 3,
wherein an average primary particle diameter of the colloidal silica is 5 to 100 nm, and an average secondary particle diameter of the colloidal silica is 10 to 300 nm.

**5.** The polishing liquid according to any one of claims 1 to 4,
wherein the organic acid is 1-hydroxyethane-1,1-diphosphonic acid.

**6.** The polishing liquid according to any one of claims 1 to 5,
wherein a content of the hypophosphorous acid is $1.0 \times 10^{-8}$% to $5.0 \times 10^{-3}$% by mass with respect to a total mass of the polishing liquid.

**7.** The polishing liquid according to any one of claims 1 to 6,
wherein a mass ratio of a content of the hypophosphorous acid to a content of the organic acid is $1.0 \times 10^{-8}$ to $2.0 \times 10^{-4}$.

**8.** The polishing liquid according to any one of claims 1 to 7, further comprising:
phosphonic acid.

**9.** The polishing liquid according to claim 8,
wherein a content of the phosphonic acid is $1.0 \times 10^{-9}$% to $5.0 \times 10^{-4}$% by mass with respect to a total mass of the polishing liquid.

**10.** The polishing liquid according to claim 8 or 9,
wherein a mass ratio of a content of the phosphonic acid to the content of the organic acid is $1.0 \times 10^{-9}$ to $1.0 \times 10^{-4}$.

**11.** The polishing liquid according to any one of claims 1 to 10, further comprising:
phosphoric acid.

**12.** The polishing liquid according to claim 11,

wherein a mass ratio of a content of the phosphoric acid to a content of the organic acid is $1.5 \times 10^{-8}$ to $3.0 \times 10^{-5}$.

**13.** The polishing liquid according to claim 11 or 12,
wherein a mass ratio of a content of the phosphoric acid to a content of the hypophosphorous acid is $1.0 \times 10^{-4}$ to $1.0 \times 10^{1}$.

**14.** The polishing liquid according to any one of claims 1 to 13, further comprising:

phosphonic acid; and
phosphoric acid,
wherein a mass ratio of a content of the phosphoric acid to a content of the phosphonic acid is $1.0 \times 10^{-2}$ to $1.0 \times 10^{2}$.

**15.** The polishing liquid according to any one of claims 1 to 14, further comprising:
ammonia.

**16.** The polishing liquid according to any one of claims 1 to 15, further comprising:
a surfactant having a sulfonic acid group or a salt thereof in a molecular structure.

**17.** The polishing liquid according to claim 16,
wherein the surfactant contains alkylbenzenesulfonic acid or a salt thereof or a derivative of alkylbenzenesulfonic acid or a salt thereof.

**18.** The polishing liquid according to claim 16 or 17,
wherein the surfactant contains alkyl diphenyl ether disulfonic acid or a salt thereof or a derivative of alkyl diphenyl ether disulfonic acid or a salt thereof.

**19.** The polishing liquid according to any one of claims 16 to 18,

wherein the surfactant contains a first surfactant selected from the group consisting of alkyl diphenyl ether disulfonic acid having an alkyl group having 12 carbon atoms or a salt thereof, and a derivative of alkyl diphenyl ether disulfonic acid having an alkyl group having 12 carbon atoms or a salt thereof, and a second surfactant selected from the group consisting of alkyl diphenyl ether disulfonic acid having an alkyl group having 13 carbon atoms or a salt thereof, and a derivative of alkyl diphenyl ether disulfonic acid having an alkyl group having 13 carbon atoms or a salt thereof, and
a mass ratio of a content of the second surfactant to a content of the first surfactant is $2.0 \times 10^{-2}$ to $3.0 \times 10^{-1}$.

**20.** The polishing liquid according to any one of claims 16 to 18,
wherein the surfactant contains alkyl diphenyl ether disulfonic acid or a salt thereof, and one or more compounds selected from the group consisting of alkyl diphenyl ether trisulfonic acid or a salt thereof, and alkyl diphenyl ether tetrasulfonic acid or a salt thereof.

**21.** The polishing liquid according to claim 20,
wherein a mass ratio of a total content of one or more compounds selected from the group consisting of the alkyl diphenyl ether trisulfonic acid or the salt thereof and the alkyl diphenyl ether tetrasulfonic acid or the salt thereof to a content of the alkyl diphenyl ether disulfonic acid or the salt thereof is $1.0 \times 10^{-3}$ to $1.0 \times 10^{-1}$.

**22.** The polishing liquid according to any one of claims 1 to 21, further comprising:
sulfuric acid.

**23.** The polishing liquid according to claim 22,
wherein a mass ratio of a content of the sulfuric acid to a content of the organic acid is $1.0 \times 10^{-5}$ to $3.0 \times 10^{-1}$.

**24.** The polishing liquid according to any one of claims 1 to 23, further comprising:

a surfactant having a sulfonic acid group or a salt thereof in a molecular structure; and
sulfuric acid,
wherein a mass ratio of a content of the sulfuric acid to a content of the surfactant is $3.0 \times 10^{-5}$ to $5.0 \times 10^{-1}$.

**25.** The polishing liquid according to any one of claims 1 to 24,
wherein, in a flattening step in a case of producing a semiconductor integrated circuit, the polishing liquid is used for chemical mechanical polishing of an object to be polished, which has a first layer containing silicon nitride, and a second layer containing at least one silicon-based compound selected from the group consisting of polysilicon, modified polysilicon, silicon oxide, silicon carbide, and silicon carbide oxide.

**26.** A polishing method comprising:

supplying the polishing liquid according to any one of claims 1 to 25 to a polishing pad on a polishing platen;
rotating the polishing platen; and
bringing the polishing pad and a surface to be polished of an object to be polished into contact and moving relative to each other.

## Patentansprüche

**1.** Polierflüssigkeit zur Verwendung beim chemisch-mechanischen Polieren, wobei die Polierflüssigkeit umfasst:

kolloidales Siliciumdioxid,
eine organische Säure, die mindestens eine Phosphonsäuregruppe oder ein Salz davon in einer Molekülstruktur aufweist,
Hypophosphorsäure, und
Wasser.

**2.** Polierflüssigkeit nach Anspruch 1,
wobei die Polierflüssigkeit einen pH von 2,5 bis 5,0 aufweist.

**3.** Polierflüssigkeit nach Anspruch 1 oder 2,
wobei ein Gehalt des kolloidalen Siliciumdioxids 1 % bis 5 Massen-% in Bezug auf eine Gesamtmasse der Polierflüssigkeit beträgt.

**4.** Polierflüssigkeit nach einem der Ansprüche 1 bis 3,
wobei ein durchschnittlicher Primärpartikeldurchmesser des kolloidalen Siliciumdioxids 5 bis 100 nm beträgt und ein durchschnittlicher Sekundärpartikeldurchmesser des kolloidalen Siliciumdioxids 10 bis 300 nm beträgt.

**5.** Polierflüssigkeit nach einem der Ansprüche 1 bis 4,
wobei die organische Säure 1-Hydroxyethan-1,1-diphosphonsäure ist.

**6.** Polierflüssigkeit nach einem der Ansprüche 1 bis 5,
wobei ein Gehalt der Hypophosphorsäure $1,0 \times 10^{-8}$ % bis $5,0 \times 10^{-3}$ Massen-% in Bezug auf eine Gesamtmasse der Polierflüssigkeit beträgt.

**7.** Polierflüssigkeit nach einem der Ansprüche 1 bis 6,
wobei ein Massenverhältnis eines Gehalts der Hypophosphorsäure zu einem Gehalt der organischen Säure $1,0 \times 10^{-8}$ bis $2,0 \times 10^{-4}$ beträgt.

**8.** Polierflüssigkeit nach einem der Ansprüche 1 bis 7, ferner umfassend:
Phosphonsäure.

**9.** Polierflüssigkeit nach Anspruch 8,
wobei ein Gehalt der Phosphonsäure $1,0 \times 10^{-9}$ % bis $5,0 \times 10^{-4}$ Massen-% in Bezug auf eine Gesamtmasse der Polierflüssigkeit beträgt.

**10.** Polierflüssigkeit nach Anspruch 8 oder 9,
wobei ein Massenverhältnis eines Gehalts der Phosphonsäure zu dem Gehalt der organischen Säure $1,0 \times 10^{-9}$ bis $1,0 \times 10^{-4}$ beträgt.

**11.** Polierflüssigkeit nach einem der Ansprüche 1 bis 10, ferner umfassend:

Phosphorsäure.

12. Polierflüssigkeit nach Anspruch 11, wobei ein Massenverhältnis eines Gehalts der Phosphorsäure zu einem Gehalt der organischen Säure $1,5 \times 10^{-8}$ bis $3,0 \times 10^{-5}$ beträgt.

13. Polierflüssigkeit nach Anspruch 11 oder 12, wobei ein Massenverhältnis eines Gehalts der Phosphorsäure zu einem Gehalt der Hypophosphorsäure $1,0 \times 10^{-4}$ bis $1,0 \times 10^{1}$ beträgt.

14. Polierflüssigkeit nach einem der Ansprüche 1 bis 13, ferner umfassend:

    Phosphonsäure; und
    Phosphorsäure,
    wobei ein Massenverhältnis eines Gehalts der Phosphorsäure zu einem Gehalt der Phosphonsäure $1,0 \times 10^{-2}$ bis $1,0 \times 10^{2}$ beträgt.

15. Polierflüssigkeit nach einem der Ansprüche 1 bis 14, ferner umfassend: Ammoniak.

16. Polierflüssigkeit nach einem der Ansprüche 1 bis 15, ferner umfassend: ein Tensid, das eine Sulfonsäuregruppe oder ein Salz davon in einer Molekülstruktur aufweist.

17. Polierflüssigkeit nach Anspruch 16, wobei das Tensid Alkylbenzolsulfonsäure oder ein Salz davon oder ein Derivat von Alkylbenzolsulfonsäure oder ein Salz davon enthält.

18. Polierflüssigkeit nach Anspruch 16 oder 17, wobei das Tensid Alkyldiphenyletherdisulfonsäure oder ein Salz davon oder ein Derivat von Alkyldiphenyletherdisulfonsäure oder ein Salz davon enthält.

19. Polierflüssigkeit nach einem der Ansprüche 16 bis 18,

    wobei das Tensid ein erstes Tensid, das aus der Gruppe, die aus Alkyldiphenyletherdisulfonsäure, die eine Alkylgruppe mit 12 Kohlenstoffatomen aufweist, oder einem Salz davon und einem Derivat von Alkyldiphenyletherdisulfonsäure, die eine Alkylgruppe mit 12 Kohlenstoffatomen aufweist, oder einem Salz davon besteht, ausgewählt wird, und ein zweites Tensid, das aus der Gruppe, die aus Alkyldiphenyletherdisulfonsäure, die eine Alkylgruppe mit 13 Kohlenstoffatomen aufweist, oder einem Salz davon und einem Derivat von Alkyldiphenyletherdisulfonsäure, die eine Alkylgruppe mit 13 Kohlenstoffatomen aufweist, oder einem Salz davon besteht, ausgewählt wird, enthält, und
    ein Massenverhältnis eines Gehalts des zweiten Tensids zu einem Gehalt des ersten Tensids $2,0 \times 10^{-2}$ bis $3,0 \times 10^{-1}$ beträgt.

20. Polierflüssigkeit nach einem der Ansprüche 16 bis 18, wobei das Tensid Alkyldiphenyletherdisulfonsäure oder ein Salz davon und eine oder mehrere Verbindungen, die aus der Gruppe, die aus Alkyldiphenylethertrisulfonsäure oder einem Salz davon und Alkyldiphenylethertetrasulfonsäure oder einem Salz davon besteht, ausgewählt werden, enthält.

21. Polierflüssigkeit nach Anspruch 20, wobei ein Massenverhältnis eines Gesamtgehalts einer oder mehrerer Verbindungen, die aus der Gruppe, die aus der Alkyldiphenylethertrisulfonsäure oder dem Salz davon und der Alkyldiphenylethertetrasulfonsäure oder dem Salz davon besteht, ausgewählt werden, zu einem Gehalt der Alkyldiphenyletherdisulfonsäure oder des Salzes davon $1,0 \times 10^{-3}$ bis $1,0 \times 10^{-1}$ beträgt.

22. Polierflüssigkeit nach einem der Ansprüche 1 bis 21, ferner umfassend: Schwefelsäure.

23. Polierflüssigkeit nach Anspruch 22,

wobei ein Massenverhältnis eines Gehalts der Schwefelsäure zu einem Gehalt der organischen Säure $1{,}0 \times 10^{-5}$ bis $3{,}0 \times 10^{-1}$ beträgt.

**24.** Polierflüssigkeit nach einem der Ansprüche 1 bis 23, ferner umfassend:

ein Tensid, das eine Sulfonsäuregruppe oder ein Salz davon in einer Molekülstruktur aufweist; und
Schwefelsäure,
wobei ein Massenverhältnis eines Gehalts der Schwefelsäure zu einem Gehalt des Tensids $3{,}0 \times 10^{-5}$ bis $1{,}0 \times 10^{-1}$ beträgt.

**25.** Polierflüssigkeit nach einem der Ansprüche 1 bis 24,
wobei bei einem Abflachungsschritt in einem Fall des Produzierens einer integrierten Halbleiterschaltung die Polierflüssigkeit zum chemisch-mechanischen Polieren eines zu polierenden Objekts verwendet wird, das eine erste Schicht, die Siliciumnitrid enthält, und eine zweite Schicht, die mindestens eine Silicium-basierte Verbindung, die aus der Gruppe, die aus Polysilicium, modifiziertem Polysilicium, Siliciumoxid, Siliciumcarbid und Siliciumcarbidoxid besteht, ausgewählt wird, enthält, aufweist.

**26.** Polierverfahren, umfassend:

Zuführen der Polierflüssigkeit nach einem der Ansprüche 1 bis 25 zu einem Polierpad auf einer Polierplatte;
Drehen der Polierplatte; und
Inkontaktbringen des Polierpads und einer zu polierenden Oberfläche eines zu polierenden Objekts und relativ zueinander Bewegen.

## Revendications

**1.** Liquide de polissage pour une utilisation dans un polissage chimico-mécanique, le liquide de polissage comprenant :

de la silice colloïdale,
un acide organique ayant au moins un groupe acide phosphonique ou un sel de celui-ci dans sa structure moléculaire,
de l'acide hypophosphoreux, et
de l'eau.

**2.** Liquide de polissage selon la revendication 1,
dans lequel le liquide de polissage a un pH de 2,5 à 5,0.

**3.** Liquide de polissage selon la revendication 1 ou la revendication 2,
dans lequel une teneur en silice colloïdale est comprise entre 1 % et 5 % en masse par rapport à une masse totale du liquide de polissage.

**4.** Liquide de polissage selon l'une quelconque des revendications 1 à 3,
dans lequel un diamètre moyen des particules primaires de la silice colloïdale est de 5 à 100 nm, et un diamètre moyen des particule secondaires de la silice colloïdale est de 10 à 300 nm.

**5.** Liquide de polissage selon l'une quelconque des revendications 1 à 4,
dans lequel l'acide organique est l'acide 1-hydroxyéthane-1,1-diphosphonique.

**6.** Liquide de polissage selon l'une quelconque des revendications 1 à 5,
dans lequel une teneur en acide hypophosphoreux est comprise entre $1{,}0 \times 10^{-3}$ % et $5{,}0 \times 10^{-3}$ % en masse par rapport à une masse totale du liquide de polissage.

**7.** Liquide de polissage selon l'une quelconque des revendications 1 à 6,
dans lequel un rapport massique entre une teneur en acide hypophosphoreux et une teneur en acide organique est compris entre $1{,}0 \times 10^{-8}$ et $2{,}0 \times 10^{-4}$.

**8.** Liquide de polissage selon l'une quelconque des revendications 1 à 7, comprenant en outre :

de l'acide phosphonique.

**9.** Liquide de polissage selon la revendication 8,
dans lequel une teneur en acide phosphonique est comprise entre $1,0 \times 10^{-9}$ % et $5,0 \times 10^{-4}$ % en masse par rapport à une masse totale du liquide de polissage.

**10.** Liquide de polissage selon la revendication 8 ou la revendication 9,
dans lequel un rapport massique entre une teneur en acide phosphonique et la teneur en acide organique est compris entre $1,0 \times 10^{-9}$ et $1,0 \times 10^{-4}$.

**11.** Liquide de polissage selon l'une quelconque des revendications 1 à 10, comprenant en outre :
de l'acide phosphorique.

**12.** Liquide de polissage selon la revendication 11,
dans lequel un rapport massique entre une teneur en acide phosphorique et une teneur en acide organique est compris entre $1,5 \times 10^{-8}$ et $3,0 \times 10^{-5}$.

**13.** Liquide de polissage selon la revendication 11 ou la revendication 12,
dans lequel un rapport massique entre une teneur en acide phosphorique et une teneur en acide hypophosphoreux est compris entre $1,0 \times 10^{-4}$ et $1,0 \times 10^{1}$.

**14.** Liquide de polissage selon l'une quelconque des revendications 1 à 13, comprenant en outre :

de l'acide phosphonique ; et
de l'acide phosphorique,
dans lequel un rapport massique entre une teneur en acide phosphorique et une teneur en acide phosphonique est compris entre $1,0 \times 10^{-2}$ et $1,0 \times 10^{2}$.

**15.** Liquide de polissage selon l'une quelconque des revendications 1 à 14, comprenant en outre :
de l'ammoniac.

**16.** Liquide de polissage selon l'une quelconque des revendications 1 à 15, comprenant en outre :
un tensioactif ayant un groupe acide sulfonique ou un sel de celui-ci dans sa structure moléculaire.

**17.** Liquide de polissage selon la revendication 16,
dans lequel le tensioactif contient de l'acide alkylbenzène sulfonique ou un sel de celui-ci ou un dérivé de l'acide alkylbenzène sulfonique ou un sel de celui-ci.

**18.** Liquide de polissage selon la revendication 16 ou la revendication 17,
dans lequel le tensioactif contient de l'acide alkyl diphenyl éther disulfonique ou un sel de celui-ci ou un dérivé de l'acide alkyl diphenyl éther disulfonique ou un sel de celui-ci.

**19.** Liquide de polissage selon l'une quelconque des revendications 16 à 18,

dans lequel le tensioactif contient un premier tensioactif choisi dans le groupe constitué par l'acide alkyl diphenyl éther disulfonique ayant un groupe alkyle ayant 12 atomes de carbone ou un sel de celui-ci, et un dérivé de l'acide alkyl diphenyl éther disulfonique ayant un groupe alkyle ayant 12 atomes de carbone ou un sel de celui-ci, et un deuxième tensioactif choisi dans le groupe constitué par l'acide alkyl diphenyl éther disulfonique ayant un groupe alkyle ayant 13 atomes de carbone ou un sel de celui-ci, et un dérivé de l'acide alkyl diphenyl éther disulfonique ayant un groupe alkyle ayant 13 atomes de carbone ou un sel de celui-ci, et
un rapport massique entre une teneur en deuxième tensioactif et une teneur en premier tensioactif est compris entre $2,0 \times 10^{-2}$ et $3,0 \times 10^{-1}$.

**20.** Liquide de polissage selon l'une quelconque des revendications 16 à 18,
dans lequel le tensioactif contient de l'acide alkyl diphenyl éther disulfonique ou un sel de celui-ci, et un ou plusieurs composés choisis dans le groupe constitué par l'acide alkyl diphenyl éther trisulfonique ou un sel de celui-ci, et l'acide alkyl diphenyl éther tétrasulfonique ou un sel de celui-ci.

**21.** Liquide de polissage selon la revendication 20, dans lequel un rapport massique entre une teneur totale d'un ou plusieurs composés choisis dans le groupe constitué par l'acide alkyl diphenyl éther trisulfonique ou un sel de celui-ci et l'acide alkyl diphenyl éther tétrasulfonique ou un sel de celui-ci et une teneur en acide alkyl diphenyl éther disulfonique ou un sel de celui-ci est compris entre $1{,}0 \times 10^{-3}$ et $1{,}0 \times 10^{-1}$.

**22.** Liquide de polissage selon l'une quelconque des revendications 1 à 21, comprenant en outre : de l'acide sulfurique.

**23.** Liquide de polissage selon la revendication 22, dans lequel un rapport massique entre une teneur en acide sulfurique et une teneur en acide organique est compris entre $1{,}0 \times 10^{-5}$ et $3{,}0 \times 10^{-1}$.

**24.** Liquide de polissage selon l'une quelconque des revendications 1 à 23, comprenant en outre :

un tensioactif ayant un groupe acide sulfonique ou un sel de celui-ci dans sa structure moléculaire ; et
de l'acide sulfurique,
dans lequel un rapport massique entre une teneur en acide sulfurique et une teneur en tensioactif est compris entre $3{,}0 \times 10^{-5}$ et $1{,}0 \times 10^{-1}$.

**25.** Liquide de polissage selon l'une quelconque des revendications 1 à 24, dans lequel, dans une étape de planarisation dans un cas de fabrication d'un circuit intégré semi-conducteur, le liquide de polissage est utilisé pour un polissage chimico-mécanique d'un objet à polir, qui comporte une première couche contenant du nitrure de silicium, et une deuxième couche contenant au moins un composé à base de silicium choisi dans le groupe constitué par le polysilicium, le polysilicium modifié, l'oxyde de silicium, le carbure de silicium et l'oxyde de carbure de silicium.

**26.** Procédé de polissage comprenant :

fournir le liquide de polissage selon l'une quelconque des revendications 1 à 25 à un tampon de polissage sur un plateau de polissage ;
faire tourner le plateau de polissage ; et
mettre en contact le tampon de polissage et une surface à polir d'un objet à polir et les déplacer l'un par rapport à l'autre.

FIG. 1

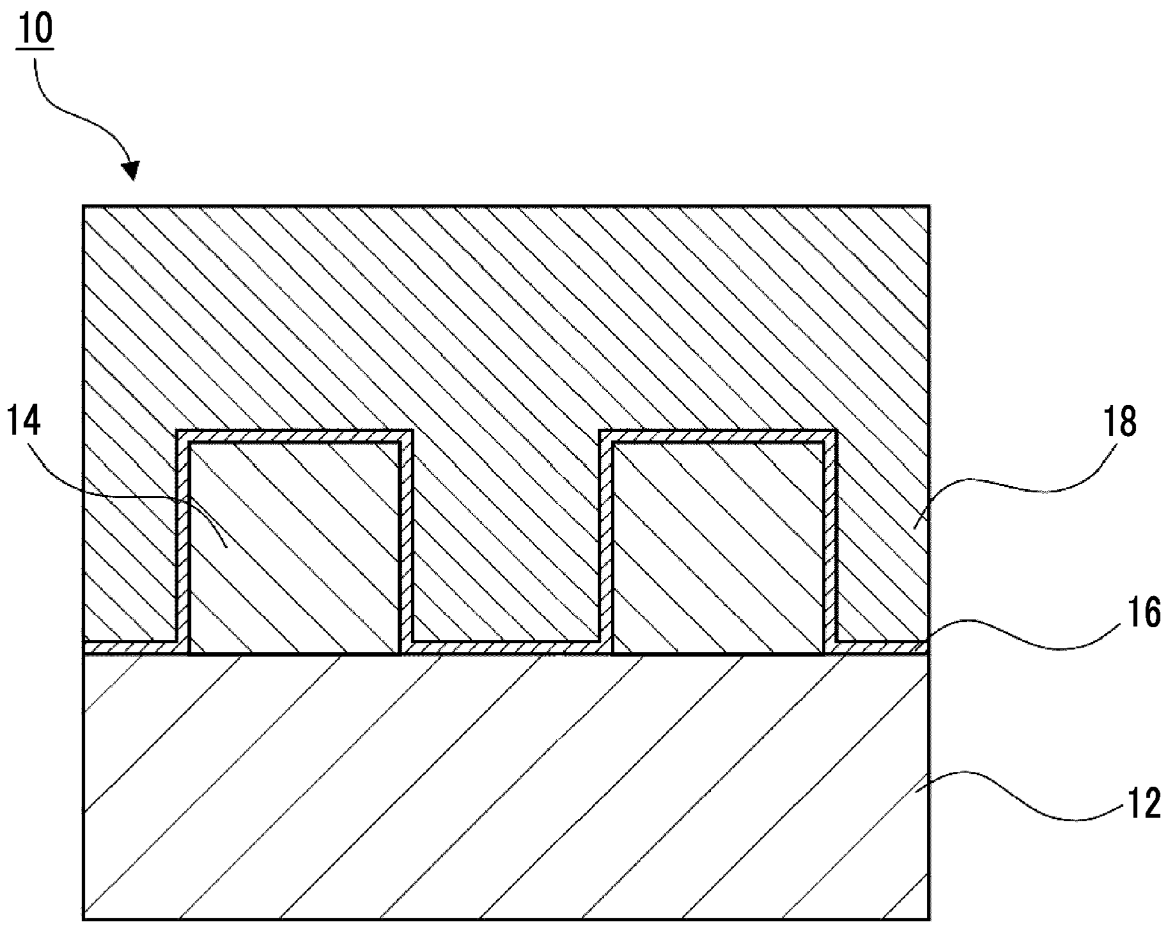

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010041037 A
- JP 3502677 A
- JP H03502677 A
- WO 2004016526 A
- WO 9946309 A
- JP 2015227501 A
- JP 2008264929 A